# EUROPÄISCHE PATENTANMELDUNG

(11) **EP 4 114 153 A1**
(43) Veröffentlichungstag der Anmeldung: **04.01.2023**
(21) Anmeldenummer: 21183469.2
(22) Anmeldetag: 02.07.2021
(51) Int. Cl.: H05K 5/02

(54) **SYSTEM UMFASSEND EIN GERÄT MIT GEHÄUSE UND EIN DARIN EINSETZBARES NETZWERKMODUL**

(71) Anmelder: CGF Counsel Group Frankfurt AG, 60549 Frankfurt (DE)
(72) Erfinder: TREIBER, Wilhelm, 96253 Untersiemau-Ziegelsdorf (DE); EIWAN, Ulrich, 83123 Amerang (DE)
(74) Vertreter: Ter Meer Steinmeister & Partner

(57) **Zusammenfassung**

Die Erfindung betrifft ein System umfassend ein Gerät mit einem Gehäuse und zumindest ein in das Gehäuse einsetzbares Netzwerkmodul, wobei am Gehäuse des Geräts ein Netzwerkanschlussträger für zumindest einen Netzwerkanschluss fixiert angeordnet ist, wobei der Netzwerkanschluss durch das Netzwerkmodul betriebsbereit ist, wobei der Netzwerkanschlussträger eine Trägeranschlussbohrung umfasst, durch die das Netzwerkmodul in das Gehäuse eingebracht und/oder aus dem Gehäuse entnommen werden kann; wobei das Netzwerkmodul einen ersten Netzwerkmodulanschluss und einen zweiten Netzwerkmodulanschluss aufweist; wobei der erste Netzwerkmodulanschluss des Netzwerkmoduls mit einem Modulanschluss des Geräts elektrisch und mechanisch lösbar verbindbar ist; wobei der zweite Netzwerkmodulanschluss des Netzwerkmoduls mit einer Leitung eines Netzwerks mechanisch lösbar verbindbar ist; wobei der Netzwerkanschlussträger eine Leitungsfixierung umfasst, um einen Stecker der Leitung des Netzwerks am Netzwerkanschlussträger mechanisch lösbar zu fixieren; wobei der zweite Netzwerkmodulanschluss des Netzwerkmoduls mit der Leitung des Netzwerks mechanisch lösbar verbindbar ist, nachdem der erste Netzwerkmodulanschluss des Netzwerkmoduls mit dem Modulanschluss des Geräts elektrisch und mechanisch lösbar verbunden ist. Die Erfindung umfasst zudem eine Außenbereichsvorrichtung, in die ein System eingebracht wird.

## Beschreibung

### TECHNISCHES GEBIET DER ERFINDUNG

Die Erfindung betrifft ein System umfassend ein Gerät mit einem Gehäuse und ein in das Gehäuse einsetzbares Netzwerkmodul. Die Erfindung betrifft zudem eine Außenbereichsvorrichtung mit einer Montagehalterung zum Verbinden/Befestigen des Systems mit der Außenbereichsvorrichtung. Die Außenbereichsvorrichtung kann ein Stadtmöbel oder ein Straßenmöbel sein. Insbesondere ist das Gerät ein elektronisches Gerät, beispielsweise eine Energieversorgungskomponente oder eine Netzwerkkomponente, beispielsweise ein aktives Kopplungselement in einem Netzwerk, wie Netzwerkweiche oder Netzwerkrouter.

### TECHNISCHER HINTERGRUND

Außenbereichsvorrichtungen (Stadtmöbel oder Straßenmöbel), wie Masten oder Schaltschränke, sind ein allgegenwärtiger Bestandteil der städtischen und ländlichen Landschaft. Beispielsweise kann ein Mast mit einer elektrischen Licht-Funktionseinheit, also einem Beleuchtungsmittel, entlang einer Straße oder eines Gehwegs angeordnet sein, um einem Autofahrer und/oder Fußgänger zu helfen, nachts besser zu sehen bzw. sich besser zu orientieren. Zusätzlich oder alternativ kann an einen Mast eine elektronische Informations-Funktionseinheit, wie Verkehrszeichen, Ampel, Verkehrszähler oder Mautprüfer, angeordnet sein, die zur Beobachtung und Steuerung eines Verkehrsflusses auf der Straße oder dem Gehweg eingesetzt wird. Zusätzlich oder alternativ kann an einem Mast ein Beobachtungs- oder Überwachungsgerät, wie eine Kamera oder ein Verkehrszähler, als elektrische Funktionseinheit angeordnet sein, die zur Beobachtung und Überwachung von Plätzen oder Straßen dient.

Außenbereichsvorrichtungen können für ein "Smart City" Konzept verwendet werden. "Smart City" ist dabei ein Sammelbegriff für ein gesamtheitliches Entwicklungskonzept, das darauf abzielt, eine Landschaft, insbesondere Städte, effizient, technologisch fortschrittlich, ökologisch und sozial inklusiv zu gestalten. Diese Konzepte sollen energieeffizient, emissionsarm, sicher und kostengünstig sein, um Zukunftsthemen, wie eine flächendeckende Breitbandvernetzung, eine flächendeckende E-Mobilität, eine Verkehrsbeobachtung bzw. -überwachung und/oder eine erhöhte Sicherheit zu ermöglichen. Dazu können die Außenbereichsvorrichtungen mit elektrischen Funktionseinheiten ausgestattet werden.

Die Funktionseinheiten kommunizieren über/mit einem Netzwerk. Eine Vielzahl von unterschiedlichen existierenden und sich weiterentwickelnden Netzwerktopologien und Signalübertragungsverfahren machen es erforderlich, einen Netzwerkanschluss für ein Gerät flexibel auszugestalten. Während einige Einstellungen über Software-Anpassungen erfolgen können, sind für andere Einstellungen und Änderungen an der Hardware notwendig.

Die Unterbringung des Geräts in einen Mast-Innenraum ist herausfordernd, da der verfügbare Raum in dem Mast limitiert ist. Ebenso ist ein Zugang zu dem Mast-Innenraum in der Regel lediglich über eine kleinflächige Wartungsöffnung in dem Mast möglich, wodurch beispielsweise die Einstellungen und Änderungen von Geräteeigenschaften in dem Mast, aber auch Wartungsarbeiten an den Geräten erschwert werden.

Die Unterbringung des Geräts an einen Mast ist dahingehend herausfordernd, dass sichergestellt werden muss, dass das Gehäuse den Umweltbedingungen standhält, also eine Schutzklasse des Gehäuses des Geräts ein definiertes Mindestmaß an Schutz bietet.

### ZUSAMMENFASSUNG DER ERFINDUNG

Der Erfindung liegt die Aufgabe zu Grunde, ein System bereitzustellen, durch das ein Gerät flexibel für unterschiedliche Netzwerke und Signalübertragungsverfahren konfiguriert werden kann. Eine weitere Aufgabe liegt darin, ein System bereitzustellen, das einfach auf einen neueres oder anderes Übertragungsverfahren adaptiert werden kann. Diese Adaption soll "im Feld" also während Wartung des Geräts in einer Außenbereichsvorrichtung ermöglicht und erleichtert werden. Auch soll das System kostengünstig herstellbar sein.

Die Aufgabe wird gelöst durch die Merkmale des unabhängigen Anspruchs. Bevorzugte Ausführungsformen sind in den abhängigen Ansprüchen angegeben.

Die Erfindung umfasst ein System umfassend ein Gerät mit einem Gehäuse und zumindest ein in das Gehäuse einsetzbares Netzwerkmodul. Am Gehäuse des Geräts ist ein Netzwerkanschlussträger für zumindest einen Netzwerkanschluss fixiert angeordnet, wobei der Netzwerkanschluss durch das Netzwerkmodul betriebsbereit ist. Der Netzwerkanschlussträger umfasst eine Trägeranschlussbohrung, durch die das Netzwerkmodul in das Gehäuse eingebracht und/oder aus dem Gehäuse entnommen werden kann. Das Netzwerkmodul weist einen ersten Netzwerkmodulanschluss und einen zweiten Netzwerkmodulanschluss auf. Der erste Netzwerkmodulanschluss des Netzwerkmoduls ist mit einem Modulanschluss des Geräts elektrisch und mechanisch lösbar verbindbar. Der zweite Netzwerkmodulanschluss des Netzwerkmoduls ist mit einer Leitung eines Netzwerks mechanisch lösbar verbindbar. Der Netzwerkanschlussträger umfasst eine Leitungsfixierung, um einen Stecker der Leitung des Netzwerks am Netzwerkanschlussträger mechanisch lösbar zu fixieren. Der zweite Netzwerkmodulanschluss des Netzwerkmoduls ist (erst) mit der Leitung des Netzwerks mechanisch lösbar verbindbar, nachdem der erste Netzwerkmodulanschluss des Netzwerkmoduls mit dem Modulanschluss des Geräts elektrisch und mechanisch lösbar verbunden ist.

Der Netzwerkanschluss umfasst damit zwei Zustände, einen ersten Zustand, in dem ein Netzwerkmodul eingesetzt ist (eingesetzter Zustand) und einen zweiten Zustand, in dem das Netzwerkmodul nicht eingesetzt ist (unbestückter Zustand).

Das Gerät umfasst bevorzugt einen zweiten, einen dritten und/oder einen vierten Netzwerkanschluss.

Erfindungsgemäß ist vorgesehen, das Gerät mit austauschbaren Netzwerkmodulen zu versehen. Dabei können nun Netzwerkmodule erst nach Auslieferung des Geräts von einem Endkunden montiert oder bereits eingesetzte Netzwerkmodule ausgetauscht werden.

Das Netzwerkmodul wird bevorzugt (händisch) von außen durch die Trägeranschlussbohrung des Netzwerkanschlussträgers in das Innere des Gehäuses eingesetzt bzw. eingesteckt bzw. mechanisch lösbar angeordnet. Die Trägeranschlussbohrung hat dazu Abmessungen, die das Einstecken des Moduls durch diese Trägeranschlussbohrung von außen ermöglichen. Das Netzwerkmodul wird dabei zum Einbringen in das Gehäuse oder zum Entnehmen aus dem Gehäuse durch die Trägeranschlussbohrung (und eine entsprechende Anschlussbohrung des Gehäuses) geführt. Die Führung kann mit einer Schiene oder einem Käfig versehen sein, um das Einbringen oder Entnehmen des Netzwerkmoduls zu vereinfachen. Zum Einbringen oder Entnehmen muss das Gehäuse des Geräts nicht geöffnet werden, wodurch Sicherheitsaspekte und Schutzmaßnahmen zur Integrität des Geräts verbessert wahrgenommen werden können.

Die Entnahme oder das Einbringen des Moduls kann unmittelbar vor der Montage des Geräts erfolgen oder auch bei bereits montierten Geräten erfolgen.

Im eingesetzten Zustand ist das Netzwerkmodul mit dem Modulanschluss des Geräts elektrisch und mechanisch lösbar verbunden und in diesem eingesetzten Zustand ist der Netzwerkanschluss betriebsbereit, sodass über diesen Netzwerkanschluss beispielsweise Daten oder Signale vom Netzwerk im Gerät empfangen werden können und über diesen Netzwerkanschluss beispielsweise Daten oder Signale vom Gerät an das Netzwerk gesendet werden können. Im unbestückten Zustand ist der Netzanschluss nicht betriebsbereit, sodass über diesen Netzwerkanschluss beispielsweise keine Daten oder keine Signale vom Netzwerk im Gerät empfangen werden können und über diesen Netzwerkanschluss beispielsweise keine Daten oder keine Signale vom Gerät an das Netzwerk gesendet werden können.

Der Netzwerkanschluss des Geräts umfasst einen Netzwerkanschlussträger. Der Netzwerkanschlussträger ist am Gerät fixiert angeordnet. Bevorzugt ist der Netzwerkanschlussträger mechanisch lösbar, beispielsweise mittels Schraubverbindungen, am Gerät angeordnet. Der Träger kann einen Teil des Netzwerkmoduls, beispielsweise den zweiten Netzwerkmodulanschluss tragen. Dazu kann der zweite Netzwerkmodulanschluss des Netzwerkmoduls in einer Aufnahme des Netzwerkanschlussträgers platziert und ggf. fixiert werden.

Der erster Netzwerkmodulanschluss kann an einem ersten Ende des Netzwerkmoduls angeordnet sein. Der zweite Netzwerkmodulanschluss kann an einem vom ersten Ende in einer Längsausrichtung des Moduls entfernten zweiten Ende des Netzwerkmoduls angeordnet sein. Somit befinden sich die Netzwerkmodulanschlüsse an jeweils gegenüberliegenden Enden des Netzwerkmoduls. Das Netzwerkmodul ist beispielsweise gemäß Multi-Source-Agreement, kurz MSA, ausgebildet und standardisiert. Beispielsweise erfüllt das Netzwerkmodul den Standard INF-8074 ("Small Form Factor Plugable Module", kurz SFP-Modul) oder den Standard SFF-8083 oder den Standard SFF-8431 ("Enhanced Small Form Factor Plugable Module", kurz SFP+ -Modul) oder den Standard SFF-8432 (Improved Plugable Form factor, kurz IPF-Modul).

Das Netzwerkmodul kann ein sogenanntes SFP-Modul sein, dessen erstes Ende den ersten Netzwerkmodulanschluss aufweist, um mit einem Modulanschluss des Geräts verbunden (gesteckt) zu werden und dessen zweites Ende den zweiten Netzwerkmodulanschluss aufweist, der vom Netzwerkanschlussträger getragen wird.

Die mechanisch lösbare Verbindung des jeweiligen Netzwerkmodulanschlusses kann durch entsprechende Steckersystem (System aus Stecker und Buchse) am Netzwerkmodul und dem Gerät bzw. der Leitung realisiert sein.

Am Netzwerkanschlussträger ist eine Leitungsfixierung vorgesehen. Diese Leitungsfixierung ermöglicht eine Fixierung einer Netzwerkleitung am Netzwerkanschluss. Dazu ist an dem Leitungsende ein Steckersystem vorgesehen, bevorzugt, um Daten oder Signale an das Gerät oder von dem Gerät zu übertragen. Am Leitungsende ist dazu ein Stecker vorgesehen, der mit einer entsprechenden Buchse als Leitungsfixierung mechanisch lösbar verbindbar ist.

Das Einsetzen des Netzwerkmoduls erfolgt zunächst ohne Verbindung des zweiten Modulanschlusses mit einem Stecker der Leitung. Das Modul wird demnach händisch durch die Trägerbohrung geführt, bis der erste Modulanschluss mit dem Modulanschluss des Geräts verbunden ist und bevorzugt der zweite Modulanschluss vom Netzwerkanschlussträger getragen wird. Nach dem Verbinden des ersten Modulanschlusses mit dem Modulanschluss des Geräts sind die elektrischen Kontakte des Modulanschlusses des Geräts vor Umwelteinflüssen geschützt. Das Tragen des zweiten Modulanschlusses am Netzwerkanschlussträger kann formschlüssig erfolgen, woraufhin das Innere des Geräts vor Umwelteinflüssen geschützt ist.

Anschließend wird das System in der Außenbereichsvorrichtung montiert und der Stecker an der Leitungsfixierung mechanisch lösbar angeordnet (diese zwei Schritte sind vertauschbar).

Der Netzwerkanschluss ist damit in flexibler Weise durch austauschbare Netzwerkmodule konfigurierbar und kann an existierende Netzwerktopologien und Übertragungsparameter angepasst werden, ohne Leitungen bzw. das Netzwerk auszutauschen zu müssen.

Das Gerät kann ein elektronisches Gerät sein. Bevorzugt ist das Gerät eine Energieversorgungskomponente oder eine Netzwerkkomponente.

Das Gerät ist beispielsweise eine aktive Netzwerkkomponente eines Netzwerkes, also ein physisches Gerät, dass für den Datenaustausch (Kommunikation und Interaktion) zwischen einer von dem Gerät entfernten Netzwerkkomponente und dem Gerät vorteilhaft ist. Das Gerät kann beispielsweise ein Gateway, ein Router, eine Netzwerkbrücke, ein Modem, ein drahtloser Zugangspunkt, eine Netzwerkweiche (Switch), ein Netzwerkverteiler (Hub) und /oder ein Repeater sein, oder umfassen. Das Gerät kann zudem eine hybride Netzwerkkomponente, wie eine Mehrschicht-Netzwerkweiche (=Multilayer-Switch), ein Protokollkonverter, ein Brückenrouter, ein Proxy-Server, eine Firewall, ein Netzwerkadressübersetzer, ein Multiplexer, ein Netzwerk-Interface-Controller sein, oder umfassen.

Bevorzugt ist das Gerät eine Netzwerkweiche. Das Netzwerk ist bevorzugt ein Metropolitan Area Network, kurz MAN. Das Netzwerk kann in einer bestimmten Bus-Topologie, beispielsweise als Stern-Bus oder als Serien-Bus (sogenanntes Daisy-Chaining), aufgebaut sein. Bei einer Daisy Chain (engl. ,Gänseblümchenkette') Topologie wird eine Anzahl von Hardware-Komponenten in Serie miteinander als Netzwerk verbunden. Dabei ist ein erstes Gerät direkt mit der entfernten Netzwerkkomponente verbunden. Weitere Geräte sind jeweils mit ihren Vorgängern (Vorgängergeräten) verbunden (Prinzip einer Reihenschaltung). So entsteht eine Kette, die sogenannte Daisy Chain. Das Signal zu und von einem Gerät wird nun über seine Vorgänger bis zur entfernten Netzwerkkomponente, beispielsweise einem Backbone oder einem Server, geleitet.

Alternativ oder zusätzlich ist das Gerät beispielsweise eine Energieversorgungskomponente.

Das Gerät umfasst bevorzugt eine aktive elektrische Komponente. Eine elektrische Komponente unterscheidet sich von passiven elektrischen Komponenten durch das Vorhandensein von Elektronik.

Die Leitung kann ein optisches Signal übertragen. Sodann verbindet der zweite Modulanschluss des Netzwerkmoduls die Leitung des Netzwerks optisch mechanisch lösbar. Dabei ist die Leitung ein Lichtwellenleiter bzw. Glasfaserkabel, das direkt an den zweiten Modulanschluss des Netzwerkmoduls angeschlossen wird. Die Leitung kann eine Single-Mode-Faser oder eine Multi-Mode-Faser sein. In dieser Ausgestaltung umfasst das Modul einen Umsetzer zum Umsetzen eines optischen Signals (von der Leitung) in ein elektrisches Signal (zum Gerät). In dieser Ausgestaltung umfasst das Modul einen Umsetzer zum Umsetzen eines elektrischen Signals (vom Gerät) in ein optisches Signal (zur Leitung).

Das Netzwerkmodul ist bevorzugt eingerichtet, den Netzwerkanschluss des Geräts zu konfigurieren. Damit ist es möglich, eine Hardware-Komponente auch nach dem Ausliefern an den Kunden auszutauschen und das Gerät für den Einsatz "im Feld" bestmöglich auszustatten.

Bevorzugt können mit dem Netzwerkmodul ein oder mehrere Parameter des Netzwerkanschlusses eingestellt werden.

Ein durch die Auswahl des Netzwerkmoduls einstellbarer Parameter ist eine Datenübertragungsrate mit der Signale über die Leitung des Netzwerks übertragen werden. Beispielhafte einstellbare Datenübertragungsrate ist 1 Giga bit pro Sekunde (Gbit/s) oder 10 Gbit/s oder 100 Gbit/s oder 1000 Gbit/s.

Ein durch die Auswahl des Netzwerkmoduls einstellbarer Parameter ist eine Signalrichtung, in der Signale über die Leitung des Netzwerks übertragen werden, insbesondere simplex, halbduplex, vollduplex oder dual-simplex Signalrichtungen, so wie sie in der Standardisierung DIN 44302 beschrieben sind für einseitige Datenübermittlung (*one-way communication*); wechselseitige Datenübermittlung (*half duplex transmission, two-way alternate communication*); beidseitige Datenübermittlung (*both-way communication, two-way simultaneous communication*); Wechselbetrieb (*half duplex transmission*) oder Gegenbetrieb (*duplex transmission*)*.*

Ein durch die Auswahl des Netzwerkmoduls einstellbarer Parameter ist ein Ausbreitungsmedium über das Signale über die Leitung des Netzwerks übertragen werden, insbesondere eine optische oder eine elektrische Signalübertragung. So kann mit einem Netzwerkmodul ein Signal empfangen /gesendet werden, dass über einen Lichtwellenleiter/Glasfaserkabel übertragen wird (optisches Signal). So kann mit einem Netzwerkmodul auch ein Signal empfangen/gesendet werden, dass über eine metallische Leitung, wie Antennen-Kabel, Koax-Kabel oder Twisted-Pair-Kabel oder Patch-Kabel übertragen wird (elektrisches Signal).

Ein durch die Auswahl des Netzwerkmoduls einstellbarer Parameter ist eine Modulationsart, wie Zeitmultiplexverfahren (TDD), Frequenzmultiplexverfahren (FDD), Codemultiplexverfahren bzw. die Art der Modulation, wie Quadraturamplitudenmodulation, QAM, Quadraturphasenumschaltung, QPSK, Frequenzmodulation, FM, Phasenmodulation, PM oder dergleichen.

Ein durch die Auswahl des Netzwerkmoduls einstellbarer Parameter ist ein Übertragungsprotokoll, mit dem die Signale übertragen werden können, wie Transportprotokoll, TCP, Internetprotokoll, IP oder dergleichen.

Der Modulanschluss des Geräts kann auf einer Leiterplatine (PCB, Leiterplatte) des Geräts angeordnet sein und ist insbesondere ein Edge-Connector. Die Leiterplatine ist im Inneren des Gehäuses. Erstreckt sich das Netzwerkmodul in einer Längsrichtung, so wird der Modulanschluss weit im Inneren des Gehäuses sein. Die elektrische und mechanisch Lösbare Verbindung des ersten Modulanschlusses des Netzwerkmoduls ist damit einfach ausgestaltet und ermöglicht ein einfaches Austauschen des Moduls.

Der Netzwerkanschlussträger kann einen Trägervorsprung umfassen, der passgenau in eine Anschlussbohrung, bevorzugt in eine Anschluss-Senkbohrung des Gehäuses des Geräts eingebracht ist, um den Netzwerkanschlussträger mit dem Gehäuse fixiert anzuordnen. Mit dieser Anordnung wird die Abmessung des Gesamtaufbaus des Netzwerkanschlusses stark verringert. Insbesondere eine Längsausrichtung des Gehäuses kann verringert werden, wenn die Netzwerkanschlüsse an einem Gehäusedeckel (oben oder unten am Gehäuse bei Betrachtung eines Einbaus in vertikaler Richtung) angeordnet sind. Ein Platzdedarf beispielsweise innerhalb einer Außenbereichsvorrichtung kann somit weiter verringert werden.

Die Verwendung einer Senkbohrung am Gehäuse ist insbesondere möglich, wenn das Gehäuse eine Gehäusedeckeldicke oder eine Gehäusewanddicke von mindestens einigen Millimetern, wie 2 mm, 5mm, 7mm oder 10mm oder mehr aufweisen muss. Dies kann beispielsweise aufgrund einer geforderten Schutzklasse IP67/IP68 zum Schutz des Geräts im Inneren des Gehäuses zur Steigerung der Robustheit, der Unabhängigkeit von Umwelteinflüssen (Vibration, Nässe, Temperatur) gefordert sein.

Eine Vorsprunghöhe des Trägervorsprungs kann einer Einsenk-Tiefe der Anschlusssenkbohrung entsprechen. So kann der Netzwerkanschlussträger maximal in eine Senkbohrung der Anschlussbohrung des Gehäuses eingebracht werden, die Gesamtausdehnung des Netzwerkanschusses wird somit stark verringert. Das Gehäuse kann kleiner ausgestaltet werden.

Die Leitungsfixierung kann ein Bajonettverschluss oder eine Schraubverbindung und/oder eine Aufsteckverbindung sein. Diese Leitungsfixierungen zeichnen sich durch einfache Handhabung aus, die wenig Platz benötigen und dennoch ein Hohes Maß an Robustheit aufweisen. Ein häufiges An- und Abklemmen der Leitungen ohne Zerstörung der Leitungsfixierung und ohne Zerstörung des Netzwerkmoduls ist damit gewährleistet.

Der Netzwerkanschlussträger kann die Leitungsfixierung umfasst, um einen Stecker der Leitung des Netzwerks am Netzwerkanschlussträger mechanisch lösbar zu fixieren.

Alle Ausführungen der Leitungsfixierung sind bevorzugt Steckersysteme. Die Leitungsfixierung kann eine Buchse (female) des Steckersystems sein und am Leitungsende ist der dazugehörige Stecker (male) angeordnet.

Der Netzwerkanschlussträger kann an einem Gehäusedeckel des Gehäuses des Geräts fixiert angeordnet, wobei bevorzugt an dem Gehäusedeckel zumindest noch ein weiterer Netzwerkanschlussträger für ein weiteren Netzwerkanschluss angeordnet ist. Der Deckel ist bei vertikaler Ausrichtung des Gehäuses das höchste Gehäuseteil oder das niedrigste Gehäuseteil des Gehäuses. Die Anordnung des weiteren Netzwerkanschlusses ermöglicht eine parallele Platzierung der Netzwerkmodule im Inneren des Gehäuses, woraufhin eine Leiterplatine platzsparend ausgestaltet werden kann.

Der Gehäusedeckel kann zumindest eine Abstufung an einer äußeren Peripherie, bevorzugt an jeder Deckelecke aufweisen. Die Abstufung ermöglicht eine weitere Platzreduzierung des Gehäuses und verringert den Aufbau bzw. den Volumenbedarf des Systems weiter.

Der Netzwerkanschlussträger kann mechanisch lösbar am Gehäuse des Geräts montiert sein, beispielsweise mittels Schraubverbindungen, wobei bei einem Austausch des Netzwerkmoduls der Netzwerkanschlussträger mit ausgetauscht werden kann. Bei einem Austausch des Netzwerkmoduls kann somit gleichzeitig der Netzwerkanschlussträger gewechselt werden, beispielsweise, um ein Netzwerkmodul, das nur mit einer bestimmten Leitungsfixierung (Bajonettverschluss etc.) ausgeliefert wird, in das Gehäuse einzustecken. Zudem kann auch eine Anforderung zur weiteren Reduktion des Platzbedarfs zu dem Austausch des Netzwerkanschlussträgers führen.

Der Austausch des Netzwerkanschlussträgers kann auch unabhängig vom Austausch eines Netzwerkmoduls erfolgen.

Die mechanisch lösbare Verbindung des Netzwerkanschlussträgers kann eine Schraube oder ein Bolzen sein.

Der Netzwerkanschlussträger kann mit einer Schutzkappe mechanisch lösbar verschließbar sein. Damit kann das Gehäuse bereits montiert werden und das Netzwerkmodul zu einem späteren Zeitpunkt platziert werden, ohne dass das Innere des Gehäuses Umwelteinflüssen (Wasser, Schmutz) ausgesetzt ist. Damit kann alternativ das Gehäuse mit dem Netzwerkmodul bestückt werden und erst danach der Einbau erfolgen. Die Schutzkappe verhindert, dass der zweite Modulanschluss des Netzwerkmoduls Umwelteinflüssen (Wasser, Schmutz) ausgesetzt ist. Die Schutzkappe kann an der Leitungsfixierung des Netzwerkanschlussträgers mechanisch lösbar fixiert werden. Beispielsweise hat die Schutzkappe die mechanische Ausgestaltung, wie ein Stecker der Leitung, die im Betrieb an den Netzanschluss angeschlossen werden soll.

Die Aufgabe wird zudem durch eine Außenbereichsvorrichtung gelöst. Die Außenbereichsvorrichtung kann mit einer Montagehalterung für ein System gemäß der zuvor beschriebenen Art ausgestaltet sein. Die Außenbereichsvorrichtung kann eine Öffnung zum Einbringen und/oder Herausnehmen des Systems aus einem Hohlraum der Außenbereichsvorrichtung aufweisen. Bei Unterbringung des Geräts (außen) an der Außenbereichsvorrichtung muss eine Schutzklasse des Gehäuses des Geräts eingehalten werden, um ein definiertes Mindestmaß an Schutz vor Umwelteinflüssen zu bieten.

Zumindest ein Netzwerkanschlussträger kann an einem Gehäusedeckel des Gehäuses des Geräts fixiert angeordnet sein, wobei bevorzugt an dem Gehäusedeckel zumindest noch ein weiterer Netzwerkanschlussträger für ein weiteren Netzwerkanschluss angeordnet ist.

Der Gehäusedeckel des Gehäuses kann nach Montage des Systems in der Außenbereichsvorrichtung an einem niedrigsten Punkt des Gehäuses bei vertikaler Ausrichtung angeordnet sein.

Die Außenbereichsvorrichtung kann ein Mast sein.

Die Halterung kann eine Bügelhalterung sein. Die Halterung kann mit einer Außenbereichsvorrichtung verbunden werden. Dadurch kann das System mit der Außenbereichsvorrichtung verbunden werden.

Eine Außenbereichsvorrichtung ist bevorzugt eine Vorrichtung, die in einem Außenbereich, wie einem öffentlichen oder privaten Platz einer Stadt oder einer ländlichen Gegend stationär installiert ist. In dem Außenbereich ist diese Außenbereichsvorrichtungen Umwelteinflüssen, wie Wetter, Vandalismus und/oder Unfallszenarien ausgesetzt.

Beispielsweise ist eine Außenbereichsvorrichtung ein Straßenmöbel (auch Stadtmöbel genannt). Ein Straßenmöbel ist ein Oberbegriff für Gegenstände in einem Außenbereich, einem öffentlichen und privaten Raum, auf einem Platz oder in einer Parkanlage. Ein Straßenmöbel bietet eine im öffentlichen Raum benötigte Funktion an oder dient der Information oder Werbung. Beispielsweise zählen Beleuchtungskörper, Lichtzeichenanlagen oder Verkehrszeichen zu Stadtmöbeln.

Beispielsweise ist eine Außenvorrichtung ein Hydrant, ein Telefonverteilkasten, ein Stromversorgungskasten, eine Litfaßsäule, ein Schaltschrank oder eine Taxi-Säule.

Bevorzugt ist eine Außenvorrichtung ein pfeilerartiger Hohlkörper, insbesondere ein Mast. Ein Mast ist hierbei ein Bauwerk mit zumindest einem hohlen pfeiler- bzw. pfostenähnlichen Innenbereich. Die Grundfläche eines Mastes ist im Vergleich zu seiner Höhe vergleichsweise gering. Der Mast dient vorrangig zur Befestigung von elektrischen Funktionseinheiten, wie beispielsweise von Beleuchtungsmitteln (Lichtmast für Straßenbeleuchtung, Flutlicht, Wegelicht, Leuchtreklame) und/oder Einheiten zur Überwachung und/oder Leitung eines Verkehrs (Wegweiser, Lichtsignalanlagen, Lichtzeichenanlagen, Verkehrsbeschilderung, Mautbrücken, Verkehrszähler) und/oder anderer elektrischer Komponenten, wie beispielsweise Antennen und/oder Ladestationen.

Die Außenbereichsvorrichtung kann einen Hohlraum aufweisen. Der Hohlraum kann sich über das gesamte Innenvolumen der Außenbereichsvorrichtung erstrecken. Die Außenbereichsvorrichtung kann ein Hohlkörper, beispielsweise in Form eines Hohlzylinders oder eines Hohlkonus oder eines Hohlkegelstumpfes, sein. Alternativ umfasst nur ein Abschnitt der Außenbereichsvorrichtung einen Hohlraum, wodurch der übrige Teil des Außenbereichsvorrichtung als massiver und stabiler Teil verbleibt, so wie es etwa bei einem massiven Pfeiler der Fall ist.

Der Hohlraum kann im Querschnitt rund, oval, dreieckig, viereckig oder mehreckig sein.

Das Gehäuse des Geräts kann Kühlrippen (=Rippen) umfassen. Eine Nut kann zwischen zwei der Kühlrippen ausgebildet sein. Ein Befestigungselement in der Nut kann als Halterung dienen.

In dem Gehäuse kann eine aktive elektrische Komponente angeordnet sein.

Das Gehäuse kann ein Metall umfassen oder aus dem Metall bestehen. Bevorzugt umfasst das Gehäuse Aluminium oder es besteht aus Aluminium.

Das Gehäuse kann eine im Wesentlichen rechteckige, dreieckige, kreisförmige oder ovale Grundform aufweisen. Bevorzugt ist die Grundform rechteckig.

Das Gehäuse kann eine erste Gehäusewand, eine zweite Gehäusewand, eine dritte Gehäusewand und eine vierte Gehäusewand aufweisen. Die erste Gehäusewand, die zweite Gehäusewand, die dritte Gehäusewand und die vierte Gehäusewand können einstückig oder monolithisch ausgebildet sein. Alternativ können die erste Gehäusewand, die zweite Gehäusewand, die dritte Gehäusewand und die vierte Gehäusewand mehrteilig ausgestaltet sein. Dabei kann jede der ersten, zweiten, dritten und vierten Gehäusewand einstückig oder monolithisch ausgebildet sein und die erste, zweite, dritte und vierte Gehäusewand können (mechanisch) miteinander verbunden werden, beispielsweise durch eine Verschraubung.

Das Gehäuse des Geräts kann einen ersten Gehäusedeckel umfassen. Das Gehäuse des Geräts kann optional einen zweiten Gehäusedeckel umfassen. Der Gehäusedeckel kann einen oder mehrere Funktionseinheiten-Anschlüsse umfassen. Der Gehäusedeckel kann Netzwerkanschlüsse umfassen.

Der Netzwerkanschlussträger kann eine Öffnung umfassen oder eine Öffnung sein. Durch die Öffnung kann ein Innenraum des Gehäuses (fluidkommunizierend) mit der Umgebung des Gehäusedeckels verbunden sein.

Ein erster Gehäusedeckel kann zwei Anschlüsse, bevorzugt drei Anschlüsse, besonders bevorzugt vier Anschlüsse, umfassen. Höchstens zwei der Anschlüsse können fluchtend an dem ersten Gehäusedeckel angeordnet sein. Mit anderen Worten, die Mittelpunkte von höchstens zwei der Anschlüsse können auf einer (gedachten) Gerade liegen.

Jeder der Anschlüsse kann ein optischer oder elektrischer Anschluss sein. Beispielsweise kann ein optischer Anschluss eine Aufnahme, insbesondere eine Steckeraufnahme, für ein Glasfaserkabel sein. Über den optischen Anschluss kann ein optisches Signal in das Gerät eingebracht werden. Ein elektrischer Anschluss kann eine Aufnahme, insbesondere eine Steckeraufnahme, für ein Datenkabel oder ein Stromkabel sein. Über den elektrischen Anschluss kann ein Datensignal oder ein elektrischer Strom in das Gerät eingebracht werden.

Der erste Gehäusedeckel kann ein erstes Ende, insbesondere ein oberes Ende, des Gehäuses abschließen. Der zweite Gehäusedeckel kann ein zweites Ende, insbesondere ein unteres Ende, des Gehäuses abschließen.

### KURZE BESCHREIBUNG DER FIGUREN

Nachfolgend wird anhand von Figuren die Erfindung bzw. weitere Ausführungsformen und Vorteile der Erfindung näher erläutert, wobei die Figuren lediglich Ausführungsbeispiele der Erfindung beschreiben. Gleiche Bestandteile in den Figuren werden mit gleichen Bezugszeichen versehen.
- Fig. 1: zeigt ein Gerät 100;
- Fig. 2a: zeigt einen Gehäusedeckel 1016 des Geräts 100 in einer perspektivischen Ansicht ohne Anschlüsse;
- Fig. 2b: zeigt einen Netzwerkanschlussträger 1022 für einen Netzanschluss zur Montage an einem Gehäusedeckel 1016 gemäß Fig.2a in einer perspektivischen Ansicht ohne Modul 200;
- Fig. 3: zeigt ein System 10 umfassend das Gerät 100 der Fig. 1 und ein darin eingestecktes Modul 200 in einer Seitenansicht;
- Fig. 4a: zeigt ein Modul 200 in perspektivischer Ansicht;
- Fig. 4b: zeigt das Modul 200 aus Fig. 4a in einer anderen perspektivischen Ansicht;
- Fig. 4c: zeigt ein zu den Fig. 4a und 4b alternatives Modul 200 in einer perspektivischen Ansicht;
- Fig. 5: zeigt das Gerät aus Figur 1 in einer Draufsicht (von unten);
- Fig. 6a: zeigt einen Netzwerkanschlussträger 1022 in Draufsicht mit Duplex-Modul 200;
- Fig. 6b: zeigt den Netzwerkanschlussträger 1022 der Fig. 6a in Seitenansicht;
- Fig. 6c: zeigt einen Stecker 300 für den Netzwerkanschlussträger 1022 der Fig. 6a/b in Seitenansicht;
- Fig. 7a: zeigt einen Netzwerkanschlussträger 1022 in Draufsicht mit Simplex-Modul 200;
- Fig. 7b: zeigt den Netzwerkanschlussträger 1022 der Fig. 7a in Seitenansicht;
- Fig. 7c: zeigt einen Stecker 300 für den Netzwerkanschlussträger 1022 der Fig. 7a/b in Seitenansicht;
- Fig. 8: zeigt einen Netzwerkanschlussträger 1022 mit Schutzkappe 10225 in perspektivischer Ansicht;
- Fig. 9: zeigt eine Modulführung 1062 für eine Leiterplatine des Geräts 100;
- Fig. 10a: zeigt eine Modulführung 1062 und einen Modulanschluss 1061 auf einer Leiterplatine 106 ohne eingestecktes Modul 200;
- Fig. 10b: zeigt eine Modulführung 1062 und einen Modulanschluss 1061 auf einer Leiterplatine 106 mit eingestecktem Modul 200;
- Fig. 11: zeigt einen Modulanschluss 1061 eines Geräts 100; und
- Fig. 12: zeigt eine Außenbereichsvorrichtung 20 mit montiertem System 10 in einer Seitenansicht.

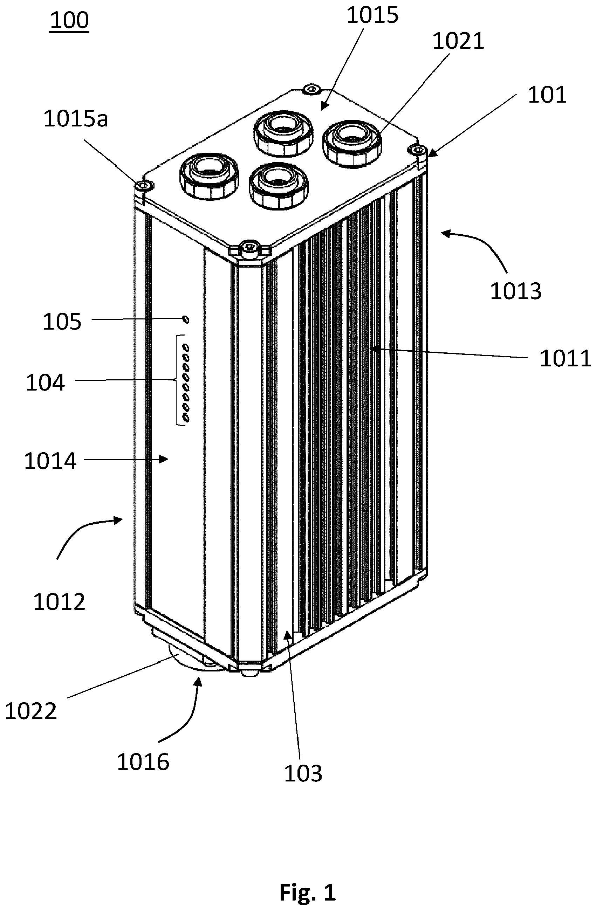

Fig. 1 zeigt ein Gerät 100 in einer perspektivischen Seitenansicht. Das Gerät 100 kann ein Gehäuse 101 umfassen. Das Gehäuse 101 kann eine erste Gehäusewand 1011, eine zweite Gehäusewand 1012 (nicht in Fig. 1 sichtbar), eine dritte Gehäusewand 1013 (nicht in Fig. 1 sichtbar) und eine vierte Gehäusewand 1014 umfassen. Nicht alle Gehäusewände sind notwendig, sondern ein Teil der Gehäusewände kann ausreichend sein.

Die erste Gehäusewand 1011 umfasst mehrere Kühlrippen, in die Befestigungselemente angeordnet sein können (nicht gezeigt in Fig. 1). Bevorzugt ist die erste Gehäusewand 1011 vollständig mit Kühlrippen versehen bzw. in der gesamten ersten Gehäusewand 1011 können Kühlrippen ausgebildet sein.

Die Fläche der ersten Gehäusewand 1011 kann größer sein als die Fläche der dritten Gehäusewand 1013. Alternativ oder zusätzlich kann die Fläche der ersten Gehäusewand 1011 größer sein als die Fläche der vierten Gehäusewand 1014.

Die zweite Gehäusewand 1012 kann analog oder gleich zu der ersten Gehäusewand 1011 ausgestaltet sein. Insbesondere kann die zweite Gehäusewand 1012 mehrere Kühlrippen umfassen.

Die erste Gehäusewand 1011 kann der zweiten Gehäusewand 1012 gegenüberliegen.

Bevorzugt umfasst die dritte Gehäusewand 1013 keine Kühlrippen. Es ist jedoch möglich, dass die dritte Gehäusewand 1013 Kühlrippen umfasst. Die dritte Gehäusewand 1013 kann die erste Gehäusewand 1011 und die zweite Gehäusewand 1012 verbinden.

Die vierte Gehäusewand 1014 umfasst bevorzugt keine Kühlrippen. Jedoch kann auch die vierte Gehäusewand 1014 Kühlrippen umfassen. Die vierte Gehäusewand 1014 kann die erste Gehäusewand 1011 und die zweite Gehäusewand 1012 verbinden. Die vierte Gehäusewand 1014 kann der dritten Gehäusewand 1013 gegenüberliegen.

Die vierte Gehäusewand 1014 kann eine Anzeige 104 umfassen. Die Anzeige 104 kann eine oder mehrere LEDs, eine oder mehrere Leuchten oder Lampen, ein oder mehrere Displays, insbesondere Touch-Displays, oder einen oder mehrere Schalter umfassen. Durch die Anzeige 104 kann einem Nutzer eine Information über den Zustand des Geräts 100 vermittelt werden. Beispielsweise wird einem Nutzer durch ein Aufleuchten einer LED signalisiert, dass das Gerät 100 betriebsbereit oder in Betrieb ist. Durch ein Aufleuchten einer anderen LED oder durch ein Aufleuchten der gleichen LED in einer anderen Farbe kann dem Nutzer signalisiert werden, dass das Gerät 100 nicht betriebsbereit oder nicht in Betrieb ist, weil beispielsweise eine Fehlfunktion oder eine Störung vorliegt.

Durch ein Aufleuchten einer anderen LED oder durch ein Aufleuchten der gleichen LED in einer anderen Farbe kann dem Nutzer signalisiert werden, dass im Gerät 100 ein Modul 200 betriebsbereit eingesteckt oder kein Modul 200 eingesteckt ist.

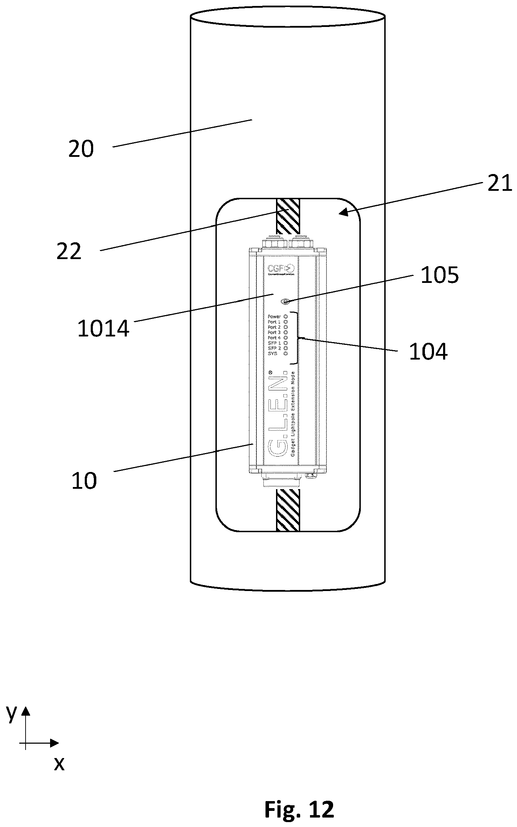

Ist das Gerät 100 mit einer Außenbereichsvorrichtung 20 (sh. Fig. 12) verbunden, kann die vierte Gehäusewand 1014 die dem Nutzer oder der Öffnung der Außenbereichsvorrichtung 20 zugewandte Seite des Geräts 100 sein. Blickt der Nutzer durch die Öffnung 21 der Außenbereichsvorrichtung 20, kann die vierte Gehäusewand 1014 die Seite des Geräts 100 sein, die dem Nutzer zugewandt ist.

Die dritte Gehäusewand 1013 kann dem Nutzer oder der Öffnung der Außenbereichsvorrichtung 20 abgewandt sein, wenn das Gerät 100 mit einer Außenbereichsvorrichtung 20 verbunden ist.

Die erste Gehäusewand 1011 und/oder die zweite Gehäusewand 1012 können Seitenwände des Geräts 100 sein.

Die erste Gehäusewand 1011, die zweite Gehäusewand 1012, die dritte Gehäusewand 1013 und die vierte Gehäusewand 1014 können einstückig oder monolithisch miteinander ausgebildet sein. Alternativ kann einige der ersten, zweiten, dritten und vierten Gehäusewände 1011, 1012, 1013, 1014 oder alle der ersten, zweiten, dritten und vierten Gehäusewände 1011, 1012, 1013, 1014 als einzelne Bauteile ausgebildet sein, die miteinander verbunden sind.

Das Gehäuse 101 des Geräts 100 kann einen ersten Gehäusedeckel 1015 umfassen, der auch als oberer Gehäusedeckel bezeichnet sein kann. Der erste Gehäusedeckel 1015 kann mit der ersten Gehäusewand 1011, der zweiten Gehäusewand 1012, der dritten Gehäusewand 1013 und der vierten Gehäusewand 1014 verbunden sein. Für diese Verbindung sind Gehäusefixierungsbohrungen 1015a am ersten Gehäusedeckel 1015 vorgesehen. Die Verbindung kann beispielsweise durch eine Verschraubung oder durch eine Klemmung erfolgen.

Der erste Gehäusedeckel 1015 kann einen Funktionseinheiten-Anschluss 1021 umfassen. Bevorzugt umfasst der erste Gehäusedeckel 1015 zumindest zwei, bevorzugt zumindest drei, bevorzugter zumindest vier, Anschlüsse 1015. Durch jeden Anschluss 1015 kann das Gerät 100 mit einer Funktionseinheit (nicht in Fig. 1 dargestellt) verbunden sein. Beispielsweise kann ein Stecker eines Kabels von dem Anschluss 1021 aufgenommen werden oder in den Anschluss 1021 eingesteckt werden. Dadurch kann eine Datenverbindung zwischen dem Gerät 100 und einem anderen Gerät, beispielsweise mit einer Funktionseinheit (nicht dargestellt in Fig. 1), hergestellt werden. Die Funktionseinheit kann beispielsweise ein Leuchtmittel, eine Verkehrsüberwachungseinheit, eine Kamera, eine Verkehrszähleinheit, eine Mauteinheit, eine KFZ-Ladestation, ein WiFi-Hotspot sein. Der Anschluss 1021 kann eingerichtet sein, elektrische Energie zur Energieversorgung des anderen Geräts, ein elektrisches Signal, ein Datensignal und/oder ein optisches Signal zu empfangen und/oder zu senden, oder in das Gerät 100 einzuleiten.

Der Anschluss 1021 kann eine Öffnung umfassen, durch die ein Innenraum des Geräts 100 mit der Umgebung des Geräts in Fluidkommunikation steht. Der Anschluss 1021 kann verschlossen sein, sodass (über den Anschluss 1021) keine Fluidkommunikation zwischen dem Innenraum des Geräts 100 und der Umgebung des Geräts 100 erfolgen kann.

Insbesondere umfasst der erste Gehäusedeckel 1015 vier Anschlüsse 1021. Die vier Anschlüsse können teilweise versetzt angeordnet sein. Bevorzugt sind höchstens zwei der Anschlüsse 1021 zueinander fluchtend angeordnet. Jeweils zwei der Anschlüsse können zueinander fluchtend angeordnet sein. Dabei kann "fluchtend" in einer von dem ersten Gehäusedeckel 1015 definierten Ebene betrachtet werden.

Das Gehäuse 101 des Geräts 100 kann einen zweiten Gehäusedeckel 1016 umfassen. Der zweite Gehäusedeckel 1016 kann auch als unterer Gehäusedeckel bezeichnet sein. Der zweite Gehäusedeckel 1016 kann mit der ersten Gehäusewand 1011, der zweiten Gehäusewand 1012, der dritten Gehäusewand 1013 und der vierten Gehäusewand 1014 verbunden sein.

Der zweite Gehäusedeckel 1016 kann einen Netzanschluss umfassen. Bevorzugt umfasst zweite Gehäusedeckel 1016 zumindest zwei, bevorzugt zumindest drei, bevorzugter zumindest vier, Netzanschlüsse. Ein Netzwerkanschlussträger 1022 für jeden Netzwerkanschluss ist fixiert am Gehäusedeckel 1016 angeordnet. Der Netzwerkanschluss ist durch Netzwerkmodul 200 (in Fig. 1 nicht dargestellt) erst betriebsbereit. Durch den Netzwerkanschluss kann das Gerät 100 mit der Umgebung verbunden sein. Beispielsweise kann ein Stecker eines Kabels von dem Netzwerkanschlussträger 1022 aufgenommen werden oder in den Netzwerkanschlussträger 1022 eingesteckt werden. Dadurch kann eine Datenverbindung zwischen dem Gerät 100 und einem anderen Gerät, beispielsweise mit einem entfernten Server über eine Leitung des Netzwerks, hergestellt werden. Der Netzwerkanschluss kann eingerichtet sein, elektrische Energie zur Energieversorgung des Geräts 100, ein elektrisches Signal, ein Datensignal und/oder ein optisches Signal zu empfangen und/oder zu senden, oder in das Gerät 100 einzuleiten.

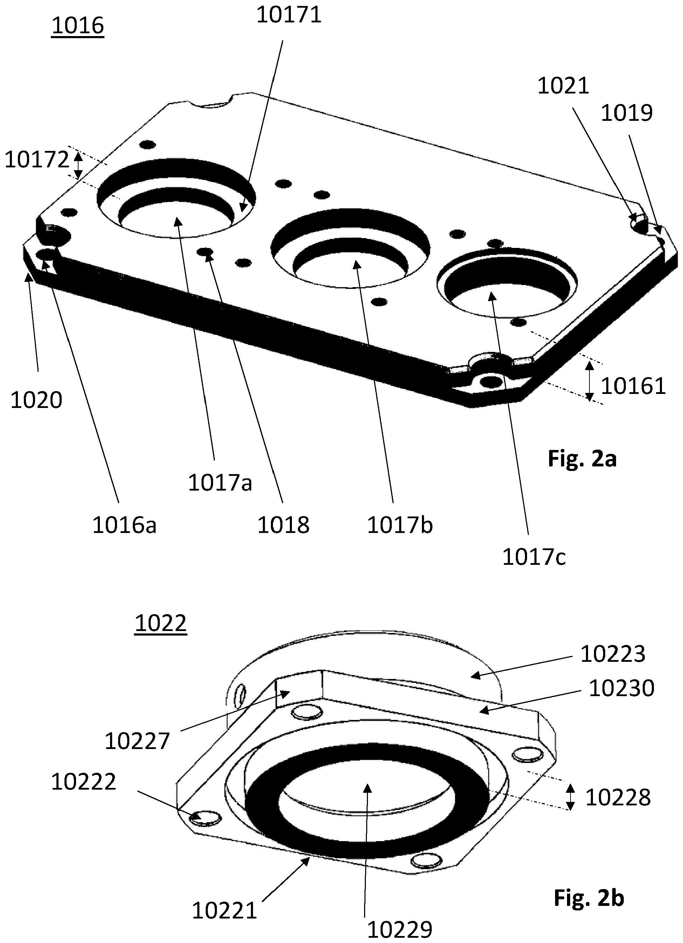

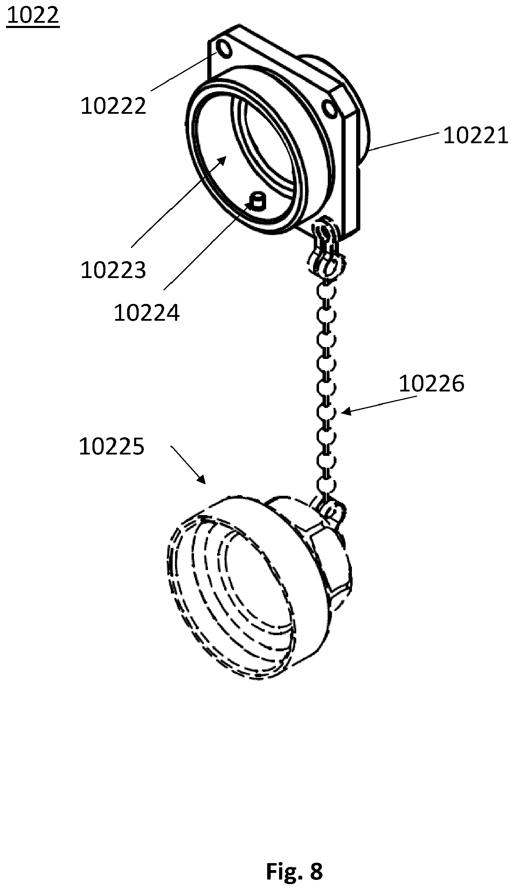

Der Netzwerkanschluss bzw. der Netzwerkanschlussträger 1022 kann eine Öffnung (hier nicht dargestellt, in Fig. 2a als 1017, in Fig. 2b als 10229) umfassen, durch die ein Innenraum des Geräts 100 mit der Umgebung des Geräts in Fluidkommunikation steht. Der Netzwerkanschlussträger 1022 kann verschlossen sein (siehe Schutzkappe 10225 in Fig. 8), sodass (über den Netzwerkanschluss) keine Fluidkommunikation zwischen dem Innenraum des Geräts 100 und der Umgebung des Geräts 100 erfolgen kann.

Fig. 2a zeigt einen Gehäusedeckel 1016 des Geräts 100 in einer perspektivischen Ansicht ohne Anschlüsse und ohne Fixierungselemente, wie Schrauben oder Bolzen, etc. zur mechanischen Verbindung zu einem anderen Gehäuseteil des Gehäuses 101 des Geräts 100. Der Gehäusedeckel 1016 kann der zweite Gehäusedeckel 1016 gemäß Fig. 1 sein.

Der Gehäusedeckel 1016 hat eine Gehäusedeckeltiefe 10161. Die Gehäusedeckeltiefe 10161 erstreckt sich von einer Oberseite des Gehäusedeckels 1016 zu einer Unterseite des Gehäusedeckels 1016. Die Gehäusedeckeltiefe 10161 kann einen Wert von 1 mm, 2 mm, 5 mm, 7mm, 8mm, 9mm, 10 mm oder mehr betragen.

Der Gehäusedeckel 1016 ist zumindest an den Kanten der Oberseite mit einer Deckelfase 1021 versehen. Die Deckelfase 1021 kann zudem auch an jeder Kante des Gehäusedeckels 1016 vorgesehen sein.

Der Gehäusedeckel 1016 kann eine quaderförmige Grundform haben. Der Gehäusedeckel 1016 kann eine Gehäusedeckelfixierungsbohrung 1016a umfassen. Die Gehäusedeckelfixierungsbohrung 1016a kann an jeder Ecke, nur an sich gegenüberliegenden Ecken oder Seiten oder nur an diagonal gegenüberliegenden Ecken des Gehäusedeckels 1016 angeordnet sein. Der Gehäusedeckel 1016 kann vier Gehäusedeckelfixierungsbohrungen 10 16a umfassen.

In Fig. 2a sind vier Gehäusedeckelfixierungsbohrungen 1016a am Gehäusedeckel 1016 vorgesehen, jeweils eine Gehäusedeckelfixierungsbohrungen 1016a ist an einer der vier Ecken des Gehäusedeckels 1016 angeordnet. In die Gehäusedeckelfixierungsbohrungen 1016a können Fixierungselemente, wie Schrauben oder Bolzen oder Stifte eingebracht werden, um den Gehäusedeckel 1016 mit anderen Gehäuseelementen, wie beispielsweise der ersten Gehäusewand 1011, der zweiten Gehäusewand 1012, der dritten Gehäusewand 1013, der vierten Gehäusewand 1014 und/oder dem Gehäusedeckel 1015, mechanisch zu verbinden. Alternativ kann eine Klemmverbindung, eine Rastverbindung oder eine Schraubverbindung vorgesehen sein, um den Gehäusedeckel 1016 mit anderen Gehäuseelementen des Gehäuses 101 des Geräts 100 zu verbinden.

Jede Ecke des Gehäusedeckels 1016 kann eine Deckeleckenstufe 1019 umfassen. Die Stufe 1019 kann eine Stufenhöhe (nicht in Fig. 2a dargestellt) umfassen. Die Stufenhöhe ist ein Abstand zwischen einer Oberseite des Gehäusedeckels 1016 und einer Oberseite der Stufe der Deckeleckenstufe 1019. Die Stufenhöhe kann 10%, 20% 25%, 30%, 40%, 50%, 60% oder 70% der Gehäusedeckeltiefe 10161 des Gehäusedeckels 1016 umfassen.

Eine oder mehrere oder alle Deckeleckenstufen 1019 können eine halbrunde Ausbuchtung in Höhe der Gehäusefixierungsbohrung 1016a umfassen, um das Fixierelement verbessert applizieren oder entnehmen zu können.

Der Gehäusedeckel 1016 kann eine Anschlussbohrung 1017 umfassen. In Fig. 2a sind drei Anschlussbohrungen 1017a, 107b, 1017c gezeigt, die nachfolgende Erläuterung gilt für alle Anschlussbohrungen 1017a, 1017b und 1017c, solange nichts anderes beschrieben ist.

Die Anschlussbohrung 1017 kann zylinderförmig, quaderförmig oder quaderförmig mit angefasten Kanten sein. Die Anschlussbohrung 1017 ist zylinderförmig.

Die Anschlussbohrung 1017 kann eine Anschluss-Senkbohrung 10171 umfassen. Die Anschluss-Senkbohrung 10171 kann zylinderförmig, quaderförmig, quaderförmig mit angefasten Kanten oder trichterförmig sein. Die Anschluss-Senkbohrung 10171 kann durch ein Senkverfahren erhalten werden. Die Anschluss-Senkbohrung 10171 weist eine Senktiefe 10172 auf. Die Senktiefe 10172 ist ein Abstand zwischen einer Oberseite des Gehäusedeckels 1016 und einer Oberseite der Senke der Senkbohrung 10171. Die Senktiefe kann 10%, 20% 25%, 30%, 40%, 50%, 60% oder 70% der Gehäusedeckeltiefe 10161 des Gehäusedeckels 1016 umfassen.

An bzw. in jede Anschlussbohrung 1017 kann ein Anschluss des Geräts 100 fixiert werden. Für diese Fixierung umfasst der Gehäusedeckel 1016 zumindest eine Anschlussfixierung. An die Anschlussbohrung 1017 kann ein Netzwerkanschluss des Geräts 100 fixiert sein. Für diese Fixierung umfasst der Gehäusedeckel 1016 zumindest eine Netzwerkanschlussfixierung. An bzw. in jede Anschlussbohrung 1017a, 1017b kann ein Netzwerkanschlussträger für ein Netzwerkanschluss des Geräts 100 fixiert sein. Für diese Fixierung kann der Gehäusedeckel 1016 zumindest eine Netzwerkanschlussträgerfixierung 1018 umfassen. Der Gehäusedeckel 1016 kann für jede Anschlussbohrung 1017a, 1017b mehr als eine, bevorzugt zwei, mehr bevorzugt drei Anschlussträgerfixierungen 1018 umfassen. Bevorzugt umfasst der Gehäusedeckel 1016 für jede Anschlussbohrung 1017a, 1017b vier Anschlussträgerfixierungen 1018, die in einem Viereck angeordnet sind.

An bzw. in die Anschlussbohrung 1017c kann ein Energieversorgungsanschluss 1023 angeordnet bzw. fixiert sein. Bevorzugt umfasst der Gehäusedeckel 1016 für die Anschlussbohrung 1017c zwei Anschlussträgerfixierungen 1018 an gegenüberliegenden Seiten der Anschlussbohrung 1017c.

Die Anschlussträgerfixierungen 1018 können Bohrungen oder Durchbohrungen umfassen. Die Anschlussträgerfixierungen können ein Innengewinde umfassen. In die Bohrung bzw. in das Innengewinde können Trägerfixierungselemente, wie Schrauben, Bolzen oder Stifte angeordnet werden, um einen Netzwerkanschlussträger (nicht gezeigt in Fig. 2a, aber in Fig. 2b dargestellt) am Gehäusedeckel 1016 des Gehäuses 101 des Geräts 100 zu fixieren.

Alternativ oder zusätzlich wird ein Anschluss des Geräts 100 in die Anschlussbohrung 1017 eingeklemmt, eingeschraubt und/oder eingerastet. In dieser Ausgestaltung kann auf Anschlussträgerfixierungen 1018 verzichtet werden.

Fig. 2b zeigt einen Netzwerkanschlussträger 1022 für einen Netzanschluss zur Montage an einem Gehäusedeckel 1016 gemäß Fig.2a in einer perspektivischen Ansicht. Der Netzwerkanschlussträger 1022 ist dabei ohne ein Modul 200 gezeigt.

Der Netzwerkanschlussträger 1022 kann einen Rahmen 10230 umfassen. Der Rahmen 10230 kann viereckig, dreieckig oder rund sein. An dem Rahmen 10230 des Netzwerkanschlussträgers 1022 sind Trägerfixierungsbohrungen 10222 vorgesehen. Am Netzwerkanschlussträger 1022 können vier Trägerfixierungsbohrungen 10222 vorgesehen sein. Die Anordnung und Anzahl der Trägerfixierungsbohrungen 10222 stimmt mit Anzahl und Anordnung der Anschlussträgerfixierung 1018 (Fig. 2a) überein, um den Netzwerkanschlussträger 1022 an bzw. in einer Anschlussbohrung 1017 des Gehäusedeckels 1016 fixieren zu können. Der Rahmen 10230 kann Trägerabschrägungen 10227 umfassen. Der Rahmen kann zudem angefast sein.

Der Netzwerkanschlussträger 1022 umfasst eine Anschlussbohrung 10229. Die Anschlussbohrung 10229 kann zylinderförmig, quaderförmig etc. geformt sein. Die Anschlussbohrung 10229 der Fig. 2b ist zylinderförmig. Der Netzwerkanschlussträger 1022 kann einen Trägervorsprung 10221 umfassen. Der Trägervorsprung 10221 kann eine Vorsprungshöhe 10228 aufweisen. Die Vorsprungshöhe 10228 ist ein Abstand zwischen einer Oberseite des Rahmens 10230 und einer Oberseite des Vorsprungs 10221. Die Vorsprungshöhe 10228 kann 10%, 20% 25%, 30%, 40%, 50%, 60% oder 70% der Gehäusedeckeltiefe 10161 des Gehäusedeckels 1016 umfassen.

Bevorzugt entspricht die Vorsprungshöhe 10228 der Senkentiefe 10172 (Fig. 2a). Damit kann der Vorsprung 10221 vollständig in die Senkbohrung 10171 eingebracht werden. Die Tiefe des Netzwerkanschlusses und damit der Platzbedarf des Geräts 100 kann damit verringert werden.

Zwischen dem Trägervorsprung 10221 und dem Rahmen 10230 kann eine Vertiefung (Rille) ausgebildet sein. In diese Vertiefung kann eine Dichtung platziert werden. Mittels der Dichtung kann der Raum zwischen Netzwerkträger 1022 mit Gehäusedeckel 1016 luftdicht und wasserdicht verschlossen werden. Damit kann trotz des modularen Aufbaus des Netzwerkanschlusses das Gerät 100 eine hohe Schutzklasse IP (bspw. IP 67 oder IP68) aufweisen.

Die Außenform des Vorsprungs 10221 entspricht bevorzugt der Innenform der Senkenbohrung 10171 (Fig. 2a).

Zur Fixierung des Netzwerkanschlussträgers 1022 am Gehäusedeckel 1016 ist vorgesehen, den Vorsprung 10221 in die Senkbohrung 10171 zu platzieren. Diese Platzierung kann passgenau sein, Vorsprung 10221 und Senkbohrung 10171 sind dann in Passung.

Der Netzwerkanschlussträger 1022 umfasst zudem eine Leitungsfixierung 10223. Die Leitungsfixierung 10223 ist eingerichtet, einen Stecker (nicht gezeigt in Fig. 2b) einer Leitung (nicht gezeigt in Fig. 2b) an den Netzwerkanschluss zu fixieren. Die Leitungsfixierung 10223 des Netzwerkanschlussträgers 1022 ermöglicht eine mechanische Verbindung zwischen Stecker und Netzwerkanschluss.

Die Leitungsfixierung 10223 kann dazu vorgesehen sein, den Stecker derart am Netzwerkanschlussträger 1022 zu fixieren, dass eine Signalübertragung über diesen Netzwerkanschluss störungsfrei, zumindest aber störungsarm, erfolgen kann.

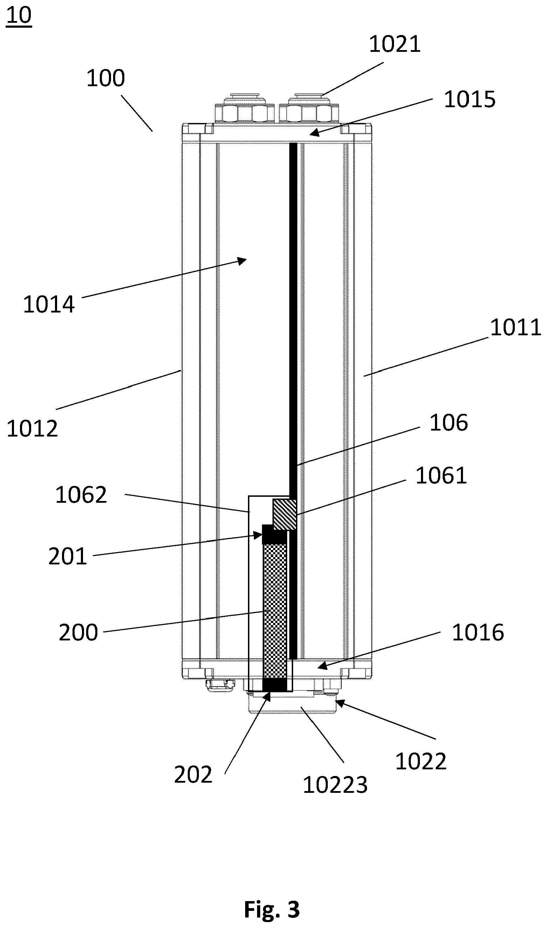

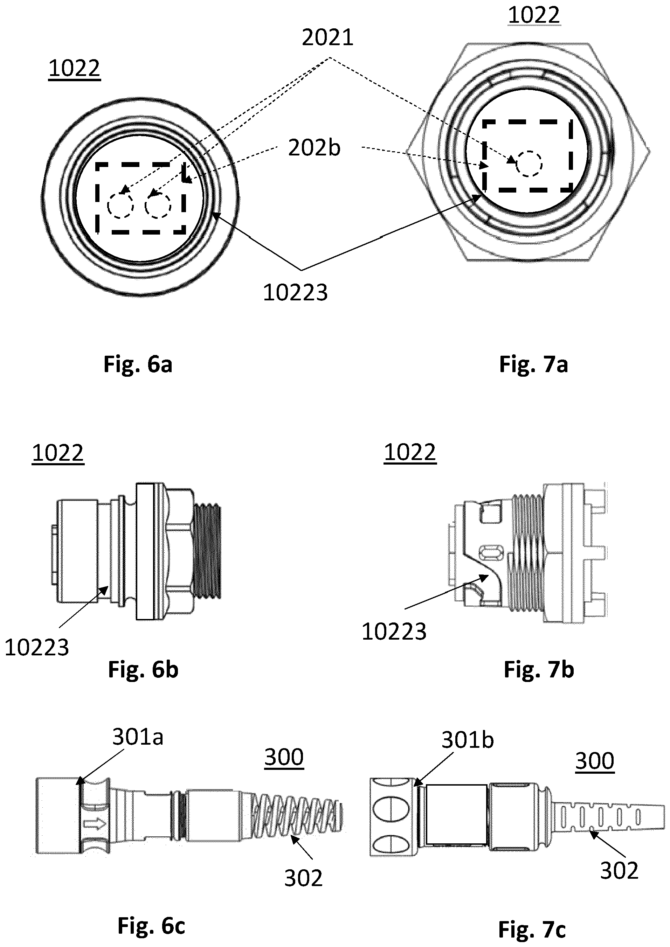

Die Fig. 3 zeigt schematisch ein System 10. Dabei zeigt Fig. 6 das System 10 in einer Seitenansicht. Das System 10 umfasst ein Gerät 100 und ein Modul 200.

Wie oben detaillierter beschrieben, kann das Gerät 100 eine erste Gehäusewand 1011, eine vierte Gehäusewand 1014, einen ersten Gehäusedeckel 1015 und einen zweiten Gehäusedeckel 1016 umfassen. Die erste Gehäusewand 1011 kann benachbart zur vierten Gehäusewand 1014 sein. Der erste Gehäusedeckel 1015 kann dem zweiten Gehäusedeckel 1016 gegenüberliegen. Alle Gehäuseteile des Gehäuses 101 können mechanisch lösbar miteinander verbunden sein.

Der zweite Gehäusedeckel 1016 kann dem Gehäusedeckel 1016 der Fig. 2a entsprechen. Am Gehäusedeckel 1016 der Fig. 3 ist nun ein Netzwerkanschlussträger 1022 gemäß Fig. 2b fixiert angeordnet, so wie es in Fig. 2b beschrieben ist. Der Netzwerkanschlussträger 1022 kann eine Leitungsfixierung 10223 umfassen, durch die ein Stecker (nicht gezeigt in Fig. 3) an dem Gerät 100 fixiert angeordnet werden kann. Mit der Leitungsfixierung 10223 kann zudem ein störungsfreies oder störungsarmes Übertragen eines Signals von einer Leitung (nicht gezeigt in Fig. 3) zum zweiten Modulanschluss 202 des Moduls 200 ermöglicht werden.

Zudem zeigt Fig. 3 ein Modul 200, das in das Innere des Geräts 100 eingesteckt ist. Das Innere des Geräts 100 ist das Volumen, das die äußeren Außenseiten des Gehäuses 100 einschließlich der Anschlüsse am Gerät 100 bilden.

Das Modul 200 kann im eingesteckten Zustand vollständig (zu 100%) im Inneren des Geräts 100 eingebracht sein. Das heißt, das gesamte Volumen des Moduls 200 ist innerhalb des Inneren des Geräts 100. Das Modul 200 kann im eingesteckten Zustand zu zumindest 90% im Inneren des Geräts 100 eingebracht sein.

Das Modul umfasst einen ersten Modulanschluss 201 und ein zweiten Modulanschluss 202. Das Modul umfasst einen ersten Modulanschluss 201 an einem ersten Ende des Moduls 200. Das Modul umfasst einen zweiten Modulanschluss 202 an einem dem ersten Ende gegenüberliegenden entfernten zweiten Ende des Moduls 200.

Das Modul 200 ist bevorzugt quaderformähnlich und hat eine Hauptausdehnung in Längsrichtung. An einem ersten Ende in Längsausrichtung ist der erste Modulanschluss 201 angeordnet. An einem vom ersten Ende entfernten zweiten Ende in Längsausrichtung ist der zweite Modulanschluss 202 angeordnet.

Der zweite Modulanschluss 202 ist bevorzugt an einer Anschlussbohrung 1017 des Gehäusedeckels 1016, mehr bevorzugt an einer Trägeranschlussbohrung 10229 des Netzanschlussträgers 1022 angeordnet. Damit ist der zweite Modulanschluss 202 im eingesteckten Zustand des Moduls 200 von außen mechanisch, optisch und/oder elektrisch - beispielsweise mittels eines Steckers (nicht in Fig. 3 gezeigt) kontaktierbar. Die Anschlussbohrung 1017 des Gehäusedeckels 1016 und/oder die Trägeranschlussbohrung 10229 des Netzanschlussträgers 1022 kann das Modul 200 und/oder den zweite Modulanschluss 202 tragen. Das Modul 200 und/oder den zweite Modulanschluss 202 kann an der Anschlussbohrung 1017 des Gehäusedeckels 1016 und/oder der Trägeranschlussbohrung 10229 des Netzanschlussträgers 1022 mechanisch fixiert sein, beispielsweise durch Einklemmen, Anschrauben, Einklicken oder Einrasten an der Anschlussbohrung 1017 des Gehäusedeckels 1016 und/oder der Trägeranschlussbohrung 10229 des Netzanschlussträgers 1022.

Der erste Modulanschluss 201 ist im eingesteckten Zustand des Moduls 200 mit einem Modulanschluss 1061 des Geräts 100 elektrisch und mechanisch verbunden. Der erste Modulanschluss 201 am Modul 200 ist derart eingerichtet, dass er bei mechanischer Verbindung mit dem Modulanschluss 1061 des Geräts 100 eine mechanisch lösbare Fixierung des Moduls 200 bewirkt. Damit kann die mechanische Verbindung zwischen erstem Modulanschluss 201 des Moduls 200 und Modulanschluss 1061 des Geräts eine Fixierung des Moduls 200 im Gerät 100 bewirken.

In Fig. 3 sind Elemente des Inneren des Gehäuses 101 angedeutet. Im Inneren des Gehäuses 101 kann sich eine Leiterplatine 106 befinden. Auf dieser Leiterplatine 106 sind elektronische und elektrische Bauelemente platziert, die die Funktion des Geräts 100 ermöglichen. Das Gerät 100 kann mehrere Leiterplatinen 106 umfassen. Die Leiterplatine(n) 106 kann (können) mehrteilig sein. Die Leiterplatine 106 kann mit einer anderen Leiterplatine (nicht gezeigt in Fig. 3) mechanisch und elektrisch verbunden sein.

Das Innere des Geräts 100 kann hohl sein. Das Innere des Geräts 100 kann Vorsprünge (nicht gezeigt in Fig. 3) an den Innenseiten des Gehäuses 101 aufweisen, die mit Bauelementen der Leiterplatine 106 physisch kontaktiert sind. Diese Vorsprünge können aus einem Material sein, dass eine Wärme des physisch kontaktierten Bauelements an die Umgebung außerhalb des Gehäuses 101 abführen kann. Dazu können Kühlrippen am Gehäuse vorgesehen sein.

Auf der Platine 106 kann der Modulanschluss 1061 des Geräts 100 angeordnet sein. Der Modulanschluss 1061 kann mechanisch und elektrisch mit der Platine 106 verbunden sein. Damit kann die mechanische Verbindung, die elektrische Verbindung und ggf. auch die Fixierung des Moduls 200 im Gerät 100 hergestellt sein.

Auf der Platine 106 kann eine Modulführung 1062 angeordnet sein. Die Modulführung 1062 kann elektrisch und/oder mechanisch mit der Platine 106 verbunden sein. Diese Modulführung 1062 kann dazu eingerichtet sein, das einsteckbare Modul 200 während des Einbringens des Moduls 200 in das Gerät 100 und/oder während des Entnehmens des Moduls 200 aus dem Gerät 100 zu führen. Auf diese Weise können Beschädigungen des Moduls 200 oder eines Elements (nicht gezeigt in Fig. 3) im Inneren des Geräts 100, beispielsweise eines Bauelements (nicht gezeigt in Fig. 3) auf der Leiterplatine 106 des Geräts 100, beispielsweise eines Elements (nicht gezeigt in Fig. 3) in unmittelbarer Nähe der Anschlussbohrung 1017 (nicht gezeigt in Fig. 3) im Inneren des Geräts 100 verhindert werden. Zudem wird mit der Modulführung 1062 das Entnehmen/Einbringen des Moduls 200 erleichtert. Beispielsweise kann die mechanische und elektrische Verbindung des ersten Modulanschlusses 201 des Moduls 200 mit dem Modulanschluss 1061 des Geräts 100 erleichtert werden. Die Modulführung 1062 kann dazu Führungselemente, wie Schienen oder Rollen, umfassen.

Die Modulführung 1062 des Geräts 100 kann alternativ oder zusätzliche eine elektromagnetische Abschirmung sein. Damit können Störsignale des Moduls 200 nicht auf das Gerät 100 einkoppeln. Damit können Störsignale des Geräts 100 nicht in das Modul 200 einkoppeln. Die Abschirmung kann elektrisch und/oder mechanisch mit der Platine 106 verbunden sein.

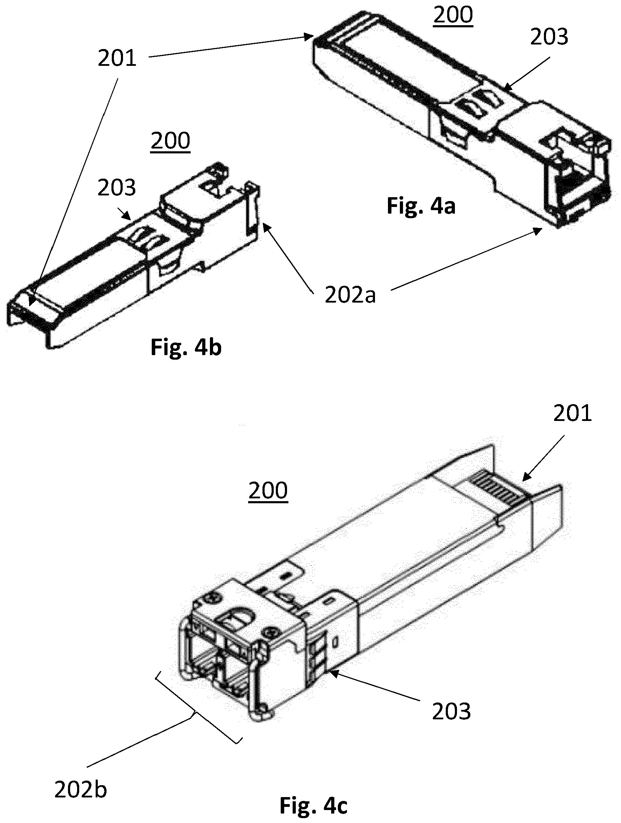

Fig. 4a zeigt ein Modul 200 in perspektivischer Ansicht, das erfindungsgemäß in ein Gerät 100 beispielsweise entsprechend der Figur 3 einsteckbar ist. Fig. 4b zeigt das Modul 200 aus Fig. 4a in einer anderen perspektivischen Ansicht. Die Fig. 4a und Fig. 4b werden nachfolgend zusammen beschrieben, um unnötige Wiederholungen zu vermeiden.

Das Modul 200 der Fig. 4a ist als einsteckbares Modul ausgebildet und kann beispielsweise standardisierte Abmessungen haben. Das Modul 200 ist beispielsweise gemäß Multi-Source-Agreement, kurz MSA, ausgebildet und standardisiert. Beispielsweise erfüllt das Modul 200 den Standard INF-8074 ("Small Form Factor Plugable Module", kurz SFP-Modul) oder den Standard SFF-8083 oder den Standard SFF-8431 ("Enhanced Small Form Factor Plugable Module", kurz SFP+ -Modul) oder den Standard SFF-8432 (Improved Plugable Form factor, kurz IPF-Modul).

Das Modul 200 der Fig. 4a ist dazu eingerichtet, in einen Netzwerkanschlussträger 1022 eines Geräts 100 eingebracht zu werden. Das Modul 200 ist ein sogenannter Transceiver, der eingerichtet ist, Daten vom Gerät 100 an das Netzwerk zu senden und Daten vom Netzwerk an das Gerät 100 zu senden.

Das Modul 200 der Fig. 4a kann dazu eingerichtet 10/100/1000Base-T Verbindungen, beispielsweise gemäß dem Standard IEEE STD 802.3 und IEEE STD 802.3ab, aufzubauen und aufrechtzuerhalten. Die Kommunikation mit einem Hostsystem kann gemäß einer SGM II Schnittstelle erfolgen. Das Modul 200 hat bevorzugt ein eigenes metallisches Gehäuse, um eine elektromagnetische Verträglichkeit, EMV, mit dem Gerät 100 zu ermöglichen. Dazu sind beispielsweise am Modul Kontaktfahnen als Abschirmungsanschluss 203 ausgebildet, die mit einer Abschirmung 1062 des Geräts 100 elektrisch verbindbar sind. Die Leistungsaufnahme dieses Moduls 200 beträgt typischerweise ca. 1 Watt und kann im Temperaturbereich von 0 bis 70 Grad Celsius eingesetzt werden.

Das Modul 200 der Fig. 4a umfasst einen ersten Modulanschluss 201, der eingerichtet ist, mit einem Modulanschluss 1061 des Geräts 100 mechanisch und elektrisch verbunden.

Das Modul 200 der Fig. 4a umfasst einen zweiten Modulanschluss 202a, der eingerichtet ist, mit einem Leitungsende einer Leitung eines Netzwerks (nicht gezeigt in Fig. 4a) mechanisch und elektrisch verbunden zu sein. In dieser Ausführung ist der zweite Modulanschluss 202 eine RJ45 Buchse, in die ein RJ45 Stecker einer Leitung eines Netzwerks angeschlossen werden kann.

Der zweite Modulanschluss 202a kann von einem Netzwerkanschlussträger 1022, beispielsweise dessen Trägeranschlussbohrung 10229 und/oder dem Gehäusedeckel 1016, beispielsweise der Anschlussbohrung 1017 getragen werden. Der zweite Modulanschluss 202a kann durch einen Netzwerkanschlussträger 1022, beispielsweise dessen Trägeranschlussbohrung 10229 und/oder dem Gehäusedeckel 1016, beispielsweise der Anschlussbohrung 1017 mechanisch fixiert werden.

Fig. 4c zeigt ein zu den Fig. 4a und 4b alternatives Modul 200 in einer perspektivischen Ansicht, das erfindungsgemäß in ein Gerät 100 beispielsweise entsprechend der Figur 3 einsteckbar ist.

Das Modul 200 der Fig. 4c ist als einsteckbares Modul ausgebildet und kann beispielsweise standardisierte Abmessungen haben. Das Modul 200 ist beispielsweise gemäß Multi-Source-Agreement, kurz MSA, ausgebildet und standardisiert. Beispielsweise erfüllt das Modul 200 den Standard INF-8074 ("Small Form Factor Plugable Module", kurz SFP-Modul) oder den Standard SFF-8083 oder den Standard SFF-8431 ("Enhanced Small Form Factor Plugable Module", kurz SFP+ -Modul) oder den Standard SFF-8432 (Improved Plugable Form factor, kurz IPF-Modul).

Das Modul 200 der Fig. 4c ist dazu eingerichtet, in einen Netzwerkanschlussträger 1022 eines Geräts 100 eingebracht zu werden. Das Modul 200 ist ein sogenannter Transceiver, der eingerichtet ist, Daten vom Gerät 100 an das Netzwerk zu senden und Daten vom Netzwerk an das Gerät 100 zu senden.

Das Modul 200 der Fig. 4c kann dazu eingerichtet bidirektionale optische Gigabit Ethernet Verbindungen, beispielsweise 1000BASE-SX oder FC-PH-2, aufzubauen und aufrechtzuerhalten. Das Modul 200 der Fig. 4c kann mit Multimode Glasfaserkabeln verbunden werden. Das Modul 200 hat bevorzugt ein eigenes metallisches Gehäuse, um eine elektromagnetische Verträglichkeit, EMV, mit dem Gerät 100 zu ermöglichen. Dazu sind beispielsweise am Modul Kontaktfahnen als Abschirmungsanschluss 203 ausgebildet, die mit einer Abschirmung 1062 des Geräts 100 elektrisch verbindbar sind. Die Datenübertragung kann bis zu 1,25 Gbps betragen.

Das Modul 200 der Fig. 4c umfasst einen ersten Modulanschluss 201, der eingerichtet ist, mit einem Modulanschluss 1061 des Geräts 100 mechanisch und elektrisch verbunden. Der erste Modulanschluss 201 des Moduls 200 der Fig. 4c kann identisch sein zum Modulanschluss 201 des Moduls 200 der Figuren 4a und 4b.

Das Modul 200 der Fig. 4c umfasst einen zweiten Modulanschluss 202b, der eingerichtet ist, mit zwei Leitungsenden einer Leitung eines Netzwerks (nicht gezeigt in Fig. 4a) mechanisch und optisch verbunden zu sein. In dieser Ausführung ist der zweite Modulanschluss 202c eine Buchse, in die ein Lichtwellenleiter-Stecker einer Duplex-Leitung eines Netzwerks angeschlossen werden kann. Eine Übertragungswellenlänge für ein optisches Signal am zweiten Anschluss 202b kann 550 nm bei einem 50/125 µm Multimode-Glasfaserkabel oder 300nm bei einem 62,5/125 µm Multimode-Glasfaserkabel betragen. Der Sender dieses Moduls 200 kann zum Versenden der optischen Signale einen VCSEL Laser beispielsweise mit einer Sendewellenlänge von 850 nm einsetzen.

Das Modul 200 der Fig. 4c kann ein Duplex-Modul sein, mit der eine bidirektionale Kommunikation über zwei getrennte Leitungen zu einem Netzwerk hergestellt werden. Mit diesem Duplex-Modul wird eine erste Leitung für das Senden von Signalen zum Gerät 100 und eine zweite Leitung für das Empfangen von Signalen vom Gerät 100 verwendet.

Alternativ (in Fig. 4c nicht dargestellt) kann ein Simplex-Modul 200 verwendet werden, bei dem (nur) eine Leitung des Netzwerks angeschlossen wird. Über diese Leitung kann dann sowohl das Senden von Signalen zum Gerät 100 als auch das Empfangen von Signalen vom Gerät 100 erfolgen. Hier kann ein Sender im Modul 200 vorgesehen, der zum Versenden der optischen Signale eine Sendewellenlänge von 1310 nm verwendet und einen Empfänger im Modul 200 vorgesehen, der dazu eingerichtet ist, optische Signale mit einer Wellenlänge von 1490 nm zu empfangen. Hier kann alternativ ein Sender im Modul 200 vorgesehen, der zum Versenden der optischen Signale eine Sendewellenlänge von 1490 nm verwendet und einen Empfänger im Modul 200 vorgesehen, der dazu eingerichtet ist, optische Signale mit einer Wellenlänge von 1310 nm zu empfangen.

Alternativ (in Fig. 4c nicht dargestellt) können Simplex-Module oder Duplex-Module verwendet werden, an die Single-Mode Glasfaserkabel angeschlossen werden können.

Der zweite Modulanschluss 202 kann von einem Netzwerkanschlussträger 1022, beispielsweise dessen Trägeranschlussbohrung 10229 und/oder dem Gehäusedeckel 1016, beispielsweise der Anschlussbohrung 1017 getragen werden. Der zweite Modulanschluss 202b kann durch einen Netzwerkanschlussträger 1022, beispielsweise dessen Trägeranschlussbohrung 10229 und/oder dem Gehäusedeckel 1016, beispielsweise der Anschlussbohrung 1017 mechanisch fixiert werden.

Die verschiedenen Ausgestaltungen der Module 200 ermöglichen eine flexible Konfiguration eines Netzwerkanschlusses eines Geräts 100. Insbesondere kann nun eine Datenübertragungsrate (1Gbit/s, 10Gbit/s, 100Gbit/s, 1000Gbit/s, etc.), mit der Signale über die Leitung des Netzwerks übertragen werden, flexibel über verschiedene Hardware-Module eingestellt werden.

Zudem kann eine Signalrichtung, in der Signale über die Leitung des Netzwerks übertragen werden, insbesondere simplex, halbduplex, vollduplex oder dual-simplex Signalrichtungen, eingestellt werden.

Zudem kann ein Ausbreitungsmedium (Glasfaser oder Metallleitung) über das Signale über die Leitung des Netzwerks übertragen werden, insbesondere eine optische oder eine elektrische Signalübertragung, flexibel sein.

Dies ermöglicht den Einsatz des Geräts 100 in verschiedenen Netzwerktopologien (simplex, duplex), für unterschiedliche Leitungstypen (Metallleitung, Multimode-Leitung, Singlemode-Leitung) und in Abhängigkeiten von Distanzen zu einem entfernten Rechensystem (Backbone-Instanz).

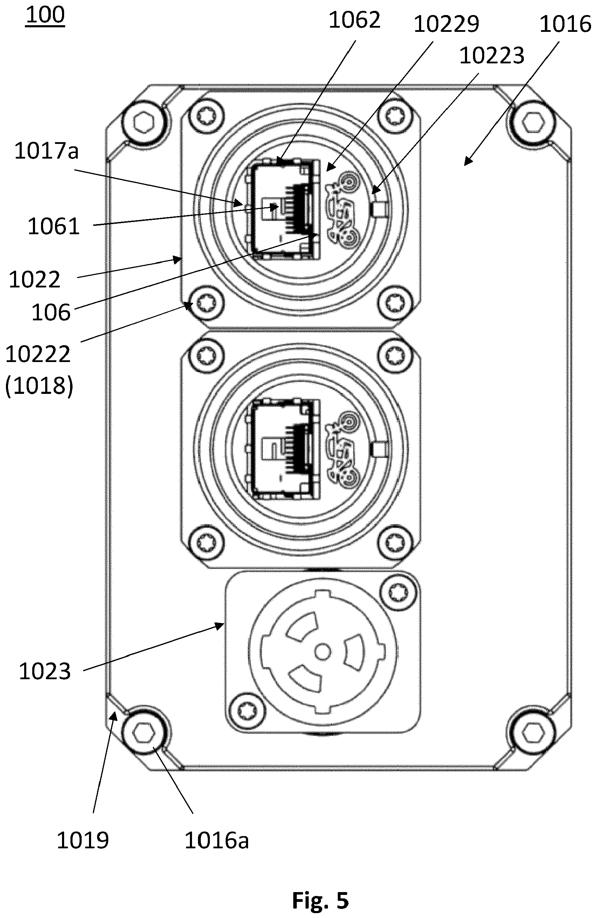

Die Fig. 5 zeigt das Gerät 100 aus Figur 1 in einer Draufsicht von unten ohne eingesteckte Module. Auf die Ausführungen zur Fig. 1, Fig. 2a und 2b und Fig. 3 wird verwiesen, um Wiederholungen zu vermeiden.

Gezeigt ist der Gehäusedeckel 1016 der Fig. 2a, der mit den Gehäusewänden 1011, 1012, 1013, 1014des Gehäuses 101 mechanisch lösbar verbunden ist. Dazu sind Schrauben als Fixierelemente in die Gehäusefixierungsbohrungen 1016a, beispielsweise mittels eines Hilfsmittels, insbesondere eines Werkzeugs, wie Schraubendreher etc., mechanisch lösbar eingebracht.

An dem Gehäusedeckel 1016 sind zwei Netzwerkanschlussträger 1022 fixiert angeordnet. Die Referenzzeichen sind nur an dem oberen Netzwerkanschluss gezeigt und zur Wahrung der Übersichtlichkeit am unteren Netzwerkanschluss nicht wiederholend gezeigt. Zudem ist ein Energieanschluss 1023 dargestellt.

In Fig. 5 sind die zwei Netzwerkanschlussträger 1022 der Fig. 2b an einem Gehäusedeckel 1016 der Fig. 2a montiert. Dazu sind Fixierelemente (Schrauben) in den Trägerfixierungsbohrungen 10222 und Anschlussträgerfixierungen 1018 eingebracht. Das Einbringen erfolgt beispielsweise mittels eines Hilfsmittels, insbesondere eines Werkzeugs, wie Schraubendreher etc.

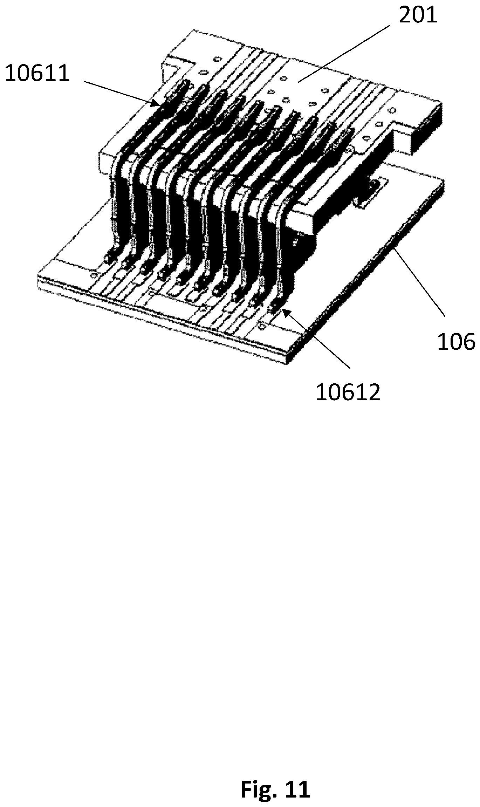

In Fig. 5 ist pro Netzwerkanschluss der Modulanschluss 1061 auf der Platine 106 des Geräts 100 in der Flucht der Trägeranschlussbohrung 10229 angeordnet. Der Modulanschluss 1061 ist beispielsweise ein Edge-Connector, wie er in Fig. 11 dargestellt ist. Die Modulführung 1062 ist mit der Platine 106 des Geräts 100 verbunden. Zudem ist die Leitungsfixierung 10223 des Netzwerkanschlussträgers 1022 als Bajonettanschluss gezeigt.

Die Fig. 6a zeigt einen Netzwerkanschlussträger 1022 in Draufsicht mit einem darin angeordneten Duplex-Modul 200 mit zwei Leitungsaufnahmen 2021 (eine für die Sende-Leitung und eine für die Empfangen-Leitung) im zweiten (optischen) Modulanschluss 202b. Eine Leitungsfixierung 10223 ist hierbei als Ansteckverbindung ausgebildet.

Die Fig. 6b zeigt den Netzwerkanschlussträger 1022 der Fig. 6a in einer Seitenansicht. Im Unterschied zur Ausgestaltung in den Fig. 2b und 5 ist in der Ausgestaltung der Fig. 6b keine Trägerfixierungsbohrung vorgesehen. Stattdessen wird der Netzwerkanschlussträger mit einer Schraubverbindung am Gehäusedeckel 1016 (nicht dargestellt in Fig. 6b) fixiert. Dazu wird eine Mutter von einer Gehäuseinnenseite auf ein Außengewinde des Netzwerkanschlussträgers 1022 platziert und fixiert. Diese Ausgestaltung spart Fläche auf dem Gehäusedeckel 1016 und verringert damit die Volumenanforderung des Gehäuses 101.

In Fig. 6c ist einen Stecker 300 für den Netzwerkanschlussträger 1022 der Fig. 6a/b in Seitenansicht dargestellt. Hierbei ist die Steckerfixierung 301a gezeigt, die mit der Leitungsfixierung 10223 der Fig. 6a/b ein Stecksystem bildet. Beispielsweise wird ein äußerer Ring der Steckerfixierung in vertikaler Richtung verschoben (siehe Pfeil), um den Stecker 300 am Netzwerkanschlussträger 1022 zu fixieren. Zudem ist in Fig. 6c eine Kabelführung des Steckers 300 gezeigt.

Die Fig. 7a zeigt einen Netzwerkanschlussträger 1022 in Draufsicht mit einem darin angeordneten Simplex-Modul 200 mit einer Leitungsaufnahmen 2021 zum Zeit- oder frequenzversetzten Senden und Empfangen im zweiten (optischen) Modulanschluss 202b. Eine Leitungsfixierung 10223 ist hierbei als Bajonettverbindung ausgebildet.

Die Fig. 7b zeigt den Netzwerkanschlussträger 1022 der Fig. 7a in Seitenansicht. Im Unterschied zur Ausgestaltung in den Fig. 2b und 5 ist in der Ausgestaltung der Fig. 7b ebenfalls keine Trägerfixierungsbohrung vorgesehen. Stattdessen wird der Netzwerkanschlussträger mit einer Schraubverbindung am Gehäusedeckel 1016 (nicht dargestellt in Fig. 7b) fixiert. Dazu wird eine Mutter auf ein Außengewinde von einer Gehäuseaußenseite des Netzwerkanschlussträgers 1022 platziert und fixiert. Diese Ausgestaltung spart Fläche auf dem Gehäusedeckel 1016 und verringert damit die Volumenanforderung des Gehäuses 101.

Fig. 7c zeigt einen Stecker 300 für den Netzwerkanschlussträger 1022 der Fig. 7a/b in Seitenansicht. Hierbei ist eine Steckerfixierung 301b gezeigt, die mit der Leitungsfixierung 10223 der Fig. 6a/b ein Bajonettsystem bildet. Beispielsweise wird ein äußerer Ring der Steckerfixierung 301b in rotiert, um den Stecker 300 am Netzwerkanschlussträger 1022 zu fixieren. Zudem ist in Fig. 7c eine Kabelführung des Steckers 300 gezeigt.

Fig. 8 zeigt einen Netzwerkanschlussträger 1022 mit einer Schutzkappe 10225 in perspektivischer Ansicht. Die Schutzkappe 10225 kann bei Auslieferung des Geräts 100 platziert werden. Das Platzieren der Schutzkappe 10225 ist unabhängig davon, ob im Netzwerkanschlussträger 1022 ein Modul 200 angeordnet ist oder nicht. Die Schutzkappe 10225 kann dazu dienen, Umwelteinflüsse, wie Schmutz, Feuchtigkeit, etc. aus dem Inneren des Gehäuses 101 des Geräts 100 fernzuhalten. Mit der Schutzkappe 10225 kann der Modulanschluss 1061 des Geräts geschützt werden, wenn beispielsweise kein Modul 200 eingesteckt ist. Mit der Schutzkappe 10225 kann der zweite Modulanschluss 200 des Moduls 200 geschützt werden, wenn beispielsweise ein Modul 200 eingesteckt ist, aber kein Stecker 300 angeschlossen ist.

Die Schutzkappe 10225 kann an einer Trägerfixierungsbohrung 10222 angeordnet werden.

Der Netzwerkanschlussträger 1022 zeigt zudem eine Leitungsfixierung 10223 in Ausgestaltung als Bajonettverschluss. Dazu ist ein Fixierknopf 10224 vorgesehen, um die Kappe 10225 oder einen Stecker 300 (nicht dargestellt in Fig. 8) korrekt ausgerichtet zu platzieren.

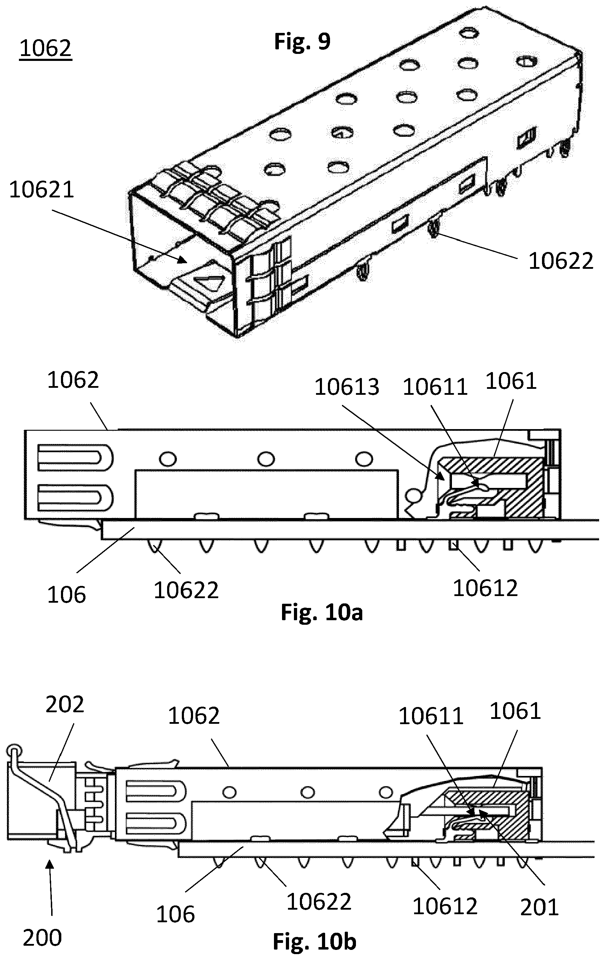

Fig. 9 zeigt eine Modulführung 1062 für eine Leiterplatine 106 des Geräts 100. Diese Modulführung 1062 wurde bereits in Fig. 3 und Fig. 5 beschrieben und auf die Ausführungen dort wird verwiesen. In Fig. 9 sind zudem Leiterplattenkontakte 10622 der Modulführung 1062 gezeigt, mit der die Modulführung 1062 auf der Platine 106 des Geräts 100 mechanisch fixiert werden kann. Ist die Modulführung 1062 zugleich eine Abschirmung, so kann mittels der Leiterplattenkontakte 10622 auch eine elektrische Kontaktierung mit der Leiterplatine 106, beispielsweise einer Masseverbindung, hergestellt werden.

Zudem zeigt die Fig. 9 eine Öffnung 10621 der Modulführung, durch die das Modul 200 in das Gerät 100 eingebracht und/oder entnommen werden kann. Die Modulführung dient beispielsweise dazu, SFP-Module der Fig. 4a-c aufzunehmen.

Die Fig. 10a zeigt eine Modulführung 1062 und einen Modulanschluss 1061 auf einer Leiterplatine 106 eines Geräts 100 ohne eingestecktes Modul 200. Dazu ist die in Fig. 9 gezeigte Modulführung 1062 in einer Seitenansicht dargestellt und es ist die mechanische/elektrische Verbindung zur Leiterplatine 106 des Geräts mittels der Leiterplattenkontakte 10622 gezeigt.

In Fig. 10a ist zudem der Modulanschluss 1061 des Geräts gezeigt. Eine perspektivische Ansicht ist in Fig. 11 gezeigt. Der Modulanschluss 1061 umfasst Leiterplattenkontakte 10612, um den Modulanschluss 1061 mechanisch und auch elektrisch mit der Platine 106 zu verbinden. Zudem sind Anschlussfähnchen 10611 gezeigt, die eine elektrisch leitende Verbindung zur Platine 106 aufweisen und die mit dem ersten Modulanschluss 201 eines Moduls 200 (siehe Fig. 10b) eine elektrisch leitende Verbindung herstellen können, wenn das Modul 200 in das Gerät 100 eingesteckt ist.

Der Modulanschluss 1061 weist zudem eine Modulaufnahmeöffnung 10613 auf, in die der erste Modulanschluss 201 des Moduls 200 geführt werden kann. Die Öffnung 10613 dient dazu, das Modul 200 mechanisch zu tragen und zu fixieren.

Der Modulanschluss 1061 ist bevorzugt ein Edge-Connector gemäß Fig. 11.

In Fig. 10b ist eine Modulführung 1062 und einen Modulanschluss 1061 auf einer Leiterplatine 106 mit eingestecktem Modul 200 gezeigt. Auf die Ausführungen der Fig. 10a wird verwiesen. Im Unterschied zu Fig. 10a ist in der Fig. 10b nun ein Modul 200 gezeigt, das mit seinem ersten Modulanschluss 201 mit dem Modulanschluss 1061 des Geräts 100 mechanisch und elektrisch verbunden ist. Diese Verbindung ist mechanisch lösbar, um das Modul 200 austauschen zu können, beispielsweise um das Gerät 100 für eine andere Netzwerktopologie oder andere Parameter der Signalübertragung zu adaptieren.

In Fig. 10b ist gezeigt, dass der zweite Anschluss 202 des Moduls 200 durch die Modulführung auch mechanisch fixiert ist. Alternativ und in Fig. 10b nicht gezeigt, ist der Netzwerkanschlussträger 1022 vorgesehen (hier nicht gezeigt), das Modul 200 zu tragen und zu fixieren.

Die Fig. 11 zeigt einen Modulanschluss 1061 eines Geräts 100 mit einem angedeuteten Teil eines Moduls 200, insbesondere dem ersten Anschluss 201 des Moduls 201. Der Modulanschluss 1061 ist in Form eines Edge-Konnektors (Eck-Verbinder) ausgestaltet, um eine einfache Modulapplizierung oder Modulentnahme im Gerät 100 zu bewerkstelligen. Der Edge-Connector ist dazu eingerichtet, erste Modulanschlüsse 201 von SFP- oder SFP+ Modulen 200 aufzunehmen.

Fig. 12 zeigt eine Außenbereichsvorrichtung 20 mit montiertem System 10 in einer Seitenansicht. Die Außenbereichsvorrichtung 20, beispielsweise ein Mast, weist eine Öffnung 21 auf. Durch die Öffnung 21 kann ein Innenraum der Außenbereichsvorrichtung 20 zugänglich sein. Die Öffnung 21 kann durch eine Klappe (nicht in Fig. 12 dargestellt) verschließbar und öffenbar sein.

Die Außenbereichsvorrichtung 20 kann eine Montagehalterung 22 umfassen. Die Montagehalterung 22 kann eine Schiene oder eine Tragschiene, bevorzugt eine Hutschiene, sein.

In der Außenbereichsvorrichtung 20 kann ein Gerät 100 angeordnet sein. Das Gerät 100 kann an der Montagehalterung 22 montiert oder fixiert sein. Insbesondere ist eine Halterung des Geräts 100 mit dem Gerät 100 und mit der Montagehalterung 22 verbunden.

Die Halterung des Geräts kann ein Halteelement umfassen (nicht dargestellt in Fig. 12). Das Halteelement 5kann mit einem Abschnitt der Halterung verbunden sein oder dort angeordnet sein, der eine Gehäusewand (1011, 1012, 1013, 1014) des Gehäuses 101 überlagert oder bedeckt. Das Halteelement kann ein Magnet, insbesondere ein Permanentmagnet, eine Schienenklammer, insbesondere eine Hutschienenklammer, eine Schraube, ein Bolzen, ein Rastelement, ein Klemmelement, ein Klettelement und/oder ein Klebeelement sein. Bevorzugt ist das Halteelement eine Klammer, bevorzugt eine Schienenklammer, bevorzugte eine Hutschienenklammer.

Durch das Halteelement kann das Gerät 100 mit einer Außenbereichsvorrichtung 20 verbunden sein. Dabei kann das Halteelement mit einer Montagehalterung 22 der Außenbereichsvorrichtung 20 verbunden sein. Die Montagehalterung 22 ist insbesondere eine Hutschiene.

Die Unterbringung eines Geräts 100 in einen Mast-Innenraum ist derart herausfordernd, da der verfügbare Raum in dem Mast limitiert ist. Ebenso ist ein Zugang zu dem Mast-Innenraum in der Regel lediglich über eine kleinflächige Wartungsöffnung in dem Mast möglich, wodurch beispielsweise die Installation des Geräts 100 in dem Mast, aber auch Wartungsarbeiten an den Geräten erschwert ist.

Mit den hier beschriebenen Maßnahmen ist einerseits eine flexible Konfiguration der Netzwerkanschlüsse des Geräts 100 durch einfaches Austauschen von den Modulen 200 ermöglicht. Zudem kann ein Platzbedarf des Geräts 100, das derartig austauschbare Modulen 200 einsetzt, erheblich reduziert werden. So kann eine Trägertiefe durch Vorsprung und Senke reduziert werden.

Durch Austausch des Trägers 1022 können verschiedene Steckersysteme unterschiedlicher Hersteller flexibel ausgetauscht werden.

Begriffe wie "erstes", "zweites", "drittes" und "viertes" unterstützen die Unterscheidung von Elementen, beispielsweise von unterschiedlichen Kühlrippen, und sind nicht einschränkend zu verstehen. Beispielsweise sind die Begriffe nicht so zu verstehen, dass mindestens vier Elemente vorhanden sein müssen, wenn ein "viertes" Element angesprochen wird.

Mit "elektrisch verbunden" wird eine elektrisch leitende Verbindung angesehen, also eine galvanische Verbindung zwischen strom- bzw. spannungsführenden Elementen.

### BEZUGSZEICHENLISTE

- 10: System
- 100: Gerät
- 101: Gehäuse
- 1011-1014: Gehäusewand
- 1015-1016: Gehäusedeckel
- 10161: Gehäusedeckeltiefe
- 1015a, 1016a: Gehäusefixierungsbohrung
- 1017a-c: Anschlussbohrung
- 10171: Anschluss-Senkbohrung
- 10172: Senkentiefe
- 1018: Anschlussträgerfixierung
- 1019: Deckeleckenstufe
- 1020: Deckelabschrägung
- 1021: Deckelfase
- 102: Geräteanschluss
- 1021: Funktionseinheitsanschluss
- 1022: Netzwerkanschlussträger für Netzwerkanschluss
- 10221: Trägervorsprung
- 10222: Trägerfixierungsbohrung
- 10223: Leitungsfixierung, Steckerfixierung
- 10224: Fixierknopf
- 10225: Schutzkappe
- 10226: Schutzkappenhalterung
- 10227: Trägerabschrägung
- 10228: Vorsprungshöhe
- 10229: Trägeranschlussbohrung
- 10230: Trägerrahmen
- 1023: Energieversorgungsanschluss
- 103: Kühlrippe
- 104: Anzeige
- 105: Sensor
- 106: Leiterplatte
- 1061: Modulanschluss
- 10611: Anschlussfähnchen
- 10612: Leiterplattenkontakt
- 10613: Modulaufnahmeöffnung
- 1062: Modulführung und Abschirmung
- 10621: Öffnung
- 10622: Leiterplattenkontakt
- 200: Netzwerkmodul
- 201: Erster Netzwerkmodulanschluss
- 202: Zweiter Netzwerkmodulanschluss
- 202a: elektrischer Modulanschluss
- 202b: optischer Modulanschluss
- 2021: Leitungsaufnahme
- 203: Abschirmungsanschluss
- 300: Stecker
- 301: Steckerfixierung
- 302: Kabelführung
- 20: Außenbereichsvorrichtung
- 21: Öffnung
- 22: Montagehalterung

## Patentansprüche

1. System (10) umfassend ein Gerät (100) mit einem Gehäuse (101) und zumindest ein in das Gehäuse (101) einsetzbares Netzwerkmodul (200),
- wobei am Gehäuse (101) des Geräts (100) ein Netzwerkanschlussträger (1022) für zumindest einen Netzwerkanschluss fixiert angeordnet ist, wobei der Netzwerkanschluss durch das Netzwerkmodul (200) betriebsbereit ist,
- wobei der Netzwerkanschlussträger (1022) eine Trägeranschlussbohrung (10229) umfasst, durch die das Netzwerkmodul (200) in das Gehäuse (101) eingebracht und/oder aus dem Gehäuse (101) entnommen werden kann;
- wobei das Netzwerkmodul (200) einen ersten Netzwerkmodulanschluss (201) und einen zweiten Netzwerkmodulanschluss (202) aufweist,
- wobei der erste Netzwerkmodulanschluss (201) des Netzwerkmoduls (200) mit einem Modulanschluss (1061) des Geräts (100) elektrisch und mechanisch lösbar verbindbar ist,
- wobei der zweite Netzwerkmodulanschluss (202) des Netzwerkmoduls (200) mit einer Leitung eines Netzwerks mechanisch lösbar verbindbar ist,
- wobei der Netzwerkanschlussträger (1022) eine Leitungsfixierung (10223) umfasst, um einen Stecker (300) der Leitung des Netzwerks am Netzwerkanschlussträger (1022) mechanisch lösbar zu fixieren,
- wobei der zweite Netzwerkmodulanschluss (202) des Netzwerkmoduls (200) mit der Leitung des Netzwerks mechanisch lösbar verbindbar ist, nachdem der erste Netzwerkmodulanschluss (201) des Netzwerkmoduls (200) mit dem Modulanschluss (1061) des Geräts (100) elektrisch und mechanisch lösbar verbunden ist.

2. Das System (10) nach Anspruch 1, wobei die Leitung ein optisches Signal überträgt und wobei der zweite Modulanschluss (202) des Netzwerkmoduls (200) die Leitung des Netzwerks optisch mechanisch lösbar verbindet.

3. Das System (10) nach einem der vorhergehenden Ansprüche, wobei das Netzwerkmodul (200) eingerichtet ist, den Netzwerkanschluss des Geräts (100) zu konfigurieren, wobei bevorzugt eines oder mehrere der folgenden Parameter für den Netzwerkanschluss mit dem Netzwerkmodul (200) eingestellt werden:
- eine Datenübertragungsrate mit der Signale über die Leitung des Netzwerks übertragen werden;
- eine Signalrichtung, in der Signale über die Leitung des Netzwerks übertragen werden, insbesondere simplex, halbduplex, vollduplex oder dual-simplex Signalrichtungen;
- ein Ausbreitungsmedium über das Signale über die Leitung des Netzwerks übertragen werden, insbesondere eine optische oder eine elektrische Signalübertragung.

4. Das System (10) nach einem der vorhergehenden Ansprüche, wobei der Modulanschluss (1061) des Geräts (100) auf einer Leiterplatine (106) des Geräts (100) angeordnet ist und insbesondere ein Edge-Connector ist.

5. Das System (10) nach einem der vorhergehenden Ansprüche, wobei der Netzwerkanschlussträger (1022) einen Trägervorsprung (10221) umfasst, der passgenau in eine Anschlussbohrung (1017), bevorzugt eine Anschluss-Senkbohrung (10171), des Gehäuses (101) des Geräts (100) eingebracht ist, um den Netzwerkanschlussträger (1022) mit dem Gehäuse (101) fixiert anzuordnen.

6. Das System (10) nach Anspruch 5, wobei eine Vorsprunghöhe (10228) des Trägervorsprungs (10221) einer Einsenk-Tiefe (10172) der Anschlusssenkbohrung (10171) entspricht.

7. Das System (10) nach einem der vorhergehenden Ansprüche, wobei die Leitungsfixierung (10223) ein Bajonettverschluss (301b) und/oder eine Schraubverbindung und/oder eine Aufsteckverbindung (301a) ist.

8. Das System (10) nach einem der vorhergehenden Ansprüche, wobei der Netzwerkanschlussträger (1022) an einem Gehäusedeckel (1016) des Gehäuses (101) des Geräts (100) fixiert angeordnet ist, wobei bevorzugt an dem Gehäusedeckel (1016) zumindest noch ein weiterer Netzwerkanschlussträger für ein weiteren Netzwerkanschluss angeordnet ist.

9. Das System (10) nach Anspruch 8, wobei der Gehäusedeckel (1016) zumindest eine Abstufung (1020) an einer äußeren Peripherie, bevorzugt an jeder Deckelecke aufweist.

10. Das System (10) nach einem der vorhergehenden Ansprüche, wobei der Netzwerkanschlussträger (1022) mechanisch lösbar am Gehäuse (101) des Geräts (100) montiert ist, wobei bei einem Austausch des Netzwerkmoduls (200) der Netzwerkanschlussträger (1022) mit ausgetauscht wird.

11. Das System (10) nach einem der vorhergehenden Ansprüche, wobei der Netzwerkanschlussträger (1022) mit einer Schutzkappe (10225) mechanisch lösbar verschließbar ist.

12. Eine Außenbereichsvorrichtung (20) mit einer Montagehalterung (22) für ein System (10) gemäß einem der vorhergehenden Ansprüche, wobei die Außenbereichsvorrichtung (20) eine Öffnung (21) zum Einbringen und/oder Herausnehmen des Systems (10) aus einem Hohlraum der Außenbereichsvorrichtung (20) aufweist.

13. Die Außenbereichsvorrichtung (20) nach Anspruch 12, wobei zumindest ein Netzwerkanschlussträger (1022) an einem Gehäusedeckel (1016) des Gehäuses (101) des Geräts (100) fixiert angeordnet ist, wobei bevorzugt an dem Gehäusedeckel (1016) zumindest noch ein weiterer Netzwerkanschlussträger für ein weiteren Netzwerkanschluss angeordnet ist.

14. Die Außenbereichsvorrichtung (20) nach Anspruch 13, wobei der Gehäusedeckel (1016) des Gehäuses (101) nach Montage des Systems (10) an einem niedrigsten Punkt des Gehäuses bei vertikaler Ausrichtung angeordnet ist.

15. Die Außenbereichsvorrichtung (20) nach einem der Ansprüche 12 bis 14, wobei die Außenbereichsvorrichtung (20) ein Mast ist.

## Geänderte Patentansprüche

### Geänderte Patentansprüche gemäss Regel 137(2) EPÜ.

1. System (10) umfassend ein Gerät (100) mit einem Gehäuse (101) und zumindest ein in das Gehäuse (101) einsetzbares Netzwerkmodul (200),
- wobei am Gehäuse (101) des Geräts (100) ein Netzwerkanschlussträger (1022) für zumindest einen Netzwerkanschluss fixiert angeordnet ist, wobei der Netzwerkanschluss durch das Netzwerkmodul (200) betriebsbereit ist,
- wobei der Netzwerkanschlussträger (1022) eine Trägeranschlussbohrung (10229) umfasst, durch die das Netzwerkmodul (200) in das Gehäuse (101) eingebracht und/oder aus dem Gehäuse (101) entnommen werden kann;
- wobei das Netzwerkmodul (200) einen ersten Netzwerkmodulanschluss (201) und einen zweiten Netzwerkmodulanschluss (202) aufweist,
- wobei der erste Netzwerkmodulanschluss (201) des Netzwerkmoduls (200) mit einem Modulanschluss (1061) des Geräts (100) elektrisch und mechanisch lösbar verbindbar ist,
- wobei der zweite Netzwerkmodulanschluss (202) des Netzwerkmoduls (200) mit einer Leitung eines Netzwerks mechanisch lösbar verbindbar ist,
- wobei der Netzwerkanschlussträger (1022) eine Leitungsfixierung (10223) umfasst, um einen Stecker (300) der Leitung des Netzwerks am Netzwerkanschlussträger (1022) mechanisch lösbar zu fixieren,
- wobei der zweite Netzwerkmodulanschluss (202) des Netzwerkmoduls (200) mit der Leitung des Netzwerks mechanisch lösbar verbindbar ist, nachdem der erste Netzwerkmodulanschluss (201) des Netzwerkmoduls (200) mit dem Modulanschluss (1061) des Geräts (100) elektrisch und mechanisch lösbar verbunden ist,
- wobei der zweite Netzwerkmodulanschluss (202) des Netzwerkmoduls (200) in einer Aufnahme des Netzwerkanschlussträgers (1022) platziert und fixiert ist,
- wobei der Netzwerkanschlussträger (1022) den zweiten Netzwerkmodulanschluss (202) des Netzwerkmoduls (200) bevorzugt formschlüssig trägt.

2. Das System (10) nach Anspruch 1, wobei die Leitung ein optisches Signal überträgt und wobei der zweite Modulanschluss (202) des Netzwerkmoduls (200) die Leitung des Netzwerks optisch mechanisch lösbar verbindet.

3. Das System (10) nach einem der vorhergehenden Ansprüche, wobei das Netzwerkmodul (200) eingerichtet ist, den Netzwerkanschluss des Geräts (100) zu konfigurieren, wobei bevorzugt eines oder mehrere der folgenden Parameter für den Netzwerkanschluss mit dem Netzwerkmodul (200) eingestellt werden:
- eine Datenübertragungsrate mit der Signale über die Leitung des Netzwerks übertragen werden;
- eine Signalrichtung, in der Signale über die Leitung des Netzwerks übertragen werden, insbesondere simplex, halbduplex, vollduplex oder dual-simplex Signalrichtungen;
- ein Ausbreitungsmedium über das Signale über die Leitung des Netzwerks übertragen werden, insbesondere eine optische oder eine elektrische Signalübertragung.

4. Das System (10) nach einem der vorhergehenden Ansprüche, wobei der Modulanschluss (1061) des Geräts (100) auf einer Leiterplatine (106) des Geräts (100) angeordnet ist und insbesondere ein Edge-Connector ist.

5. Das System (10) nach einem der vorhergehenden Ansprüche, wobei der Netzwerkanschlussträger (1022) einen Trägervorsprung (10221) umfasst, der passgenau in eine Anschlussbohrung (1017), bevorzugt eine Anschluss-Senkbohrung (10171), des Gehäuses (101) des Geräts (100) eingebracht ist, um den Netzwerkanschlussträger (1022) mit dem Gehäuse (101) fixiert anzuordnen.

6. Das System (10) nach Anspruch 5, wobei eine Vorsprunghöhe (10228) des Trägervorsprungs (10221) einer Einsenk-Tiefe (10172) der Anschlusssenkbohrung (10171) entspricht.

7. Das System (10) nach einem der vorhergehenden Ansprüche, wobei die Leitungsfixierung (10223) ein Bajonettverschluss (301b) und/oder eine Schraubverbindung und/oder eine Aufsteckverbindung (301a) ist.

8. Das System (10) nach einem der vorhergehenden Ansprüche, wobei der Netzwerkanschlussträger (1022) an einem Gehäusedeckel (1016) des Gehäuses (101) des Geräts (100) fixiert angeordnet ist, wobei bevorzugt an dem Gehäusedeckel (1016) zumindest noch ein weiterer Netzwerkanschlussträger für ein weiteren Netzwerkanschluss angeordnet ist.

9. Das System (10) nach Anspruch 8, wobei der Gehäusedeckel (1016) zumindest eine Abstufung (1020) an einer äußeren Peripherie, bevorzugt an jeder Deckelecke aufweist.

10. Das System (10) nach einem der vorhergehenden Ansprüche, wobei der Netzwerkanschlussträger (1022) mechanisch lösbar am Gehäuse (101) des Geräts (100) montiert ist, wobei bei einem Austausch des Netzwerkmoduls (200) der Netzwerkanschlussträger (1022) austauschbar ist.

11. Das System (10) nach einem der vorhergehenden Ansprüche, wobei der Netzwerkanschlussträger (1022) mit einer Schutzkappe (10225) mechanisch lösbar verschließbar ist.

12. Eine Außenbereichsvorrichtung (20) mit einem System (10) gemäß einem der vorhergehenden Ansprüche und einer Montagehalterung (22) für das System (10), wobei die Außenbereichsvorrichtung (20) eine Öffnung (21) zum Einbringen und/oder Herausnehmen des Systems (10) aus einem Hohlraum der Außenbereichsvorrichtung (20) aufweist.

13. Die Außenbereichsvorrichtung (20) nach Anspruch 12, wobei zumindest ein Netzwerkanschlussträger (1022) an einem Gehäusedeckel (1016) des Gehäuses (101) des Geräts (100) fixiert angeordnet ist, wobei bevorzugt an dem Gehäusedeckel (1016) zumindest noch ein weiterer Netzwerkanschlussträger für ein weiteren Netzwerkanschluss angeordnet ist.

14. Die Außenbereichsvorrichtung (20) nach Anspruch 13, wobei der Gehäusedeckel (1016) des Gehäuses (101) nach Montage des Systems (10) an einem niedrigsten Punkt des Gehäuses bei vertikaler Ausrichtung angeordnet ist.

15. Die Außenbereichsvorrichtung (20) nach einem der Ansprüche 12 bis 14, wobei die Außenbereichsvorrichtung (20) ein Mast ist.
